(19) Europäisches Patentamt
European Patent Office
Office européen des brevets

(11) **EP 1 936 555 A1**

(12) **EUROPEAN PATENT APPLICATION**
published in accordance with Art. 153(4) EPC

(43) Date of publication:
**25.06.2008 Bulletin 2008/26**

(21) Application number: **06810443.9**

(22) Date of filing: **22.09.2006**

(51) Int Cl.:
*G06Q 10/00* (2006.01)    *G06F 19/00* (2006.01)

(86) International application number:
**PCT/JP2006/318830**

(87) International publication number:
**WO 2007/037178 (05.04.2007 Gazette 2007/14)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **29.09.2005 JP 2005283473**

(71) Applicant: **Japan Tobacco, Inc.**
**Tokyo 105-8422 (JP)**

(72) Inventors:
• **HIRAI, Hiroto**
**Minato-ku Tokyo, 1058422 (JP)**

• **ISHIDA, Osamu**
**2-1 Toranomon 2-chome**
**Minato-ku Tokyo 1058422 (JP)**
• **IWASE, Kentaro**
**Minato-ku Tokyo, 1058422 (JP)**

(74) Representative: **Skuhra, Udo**
**Reinhard-Skuhra-Weise & Partner GbR**
**Friedrichstrasse 31**
**80801 München (DE)**

(54) **SIMULATOR, EFFECT MEASURING DEVICE, AND SALE PROMOTION SUPPORTING SYSTEM**

(57)    There is provided a simulation apparatus that predicts an effect of sending out a direct mail for a product of a specific brand, including a planned budget acceptance unit 102 that accepts a planned budget of the campaign, a customer master 108 containing properties and turn-away probability of each customer, a condition acceptance unit 112 that accepts a condition for sending the direct mail, a number of DM delivery calculation unit 114 that extracts the customers to whom the condition applies out of the customer master 108 and calculates the number of customers to whom the direct mail may be sent, a plan acceptance unit 116 that accepts a planned number of customers to whom the direct mail should be sent and the expected conversion rate, a unit value table 118 that stores therein a unit value of a brand newly chosen because of the DM and predetermined with respect to each of the properties of the brand of the product, an expected value calculation unit 120 that calculates the number of conversion-expected customers and the expected earned value, an expected ROI calculation unit 122, and a planning-phase screen display unit 106 that presents the number of customers to whom the direct mail may be sent, the expected earned value and the expected ROI.

Fig.2

EP 1 936 555 A1

**Description**

TECHNICAL FIELD

The present invention relates to a simulation apparatus, an effect measurement apparatus and a sales promotion support system, and more particularly to a simulation apparatus and an effect measurement apparatus of an effect of a campaign carried out through sending direct mails or distributing merchandise samples based on a one to one marketing method, and to a sales promotion support system.

BACKGROUND ART

Conventionally, companies have been carrying out detailed management analysis and planning sales strategies and so forth utilizing an index of "Return On Investment" (hereinafter, ROI) which indicates the profit earned with respect to the capital invested. Conventional investment and collection simulation systems include the one described in, for example, in JP-A No.2003-91630.
The system described therein efficiently establishes an investment and collection model in developing or purchasing merchandise such as products and services, and simulates financial parameters useful for risk assessment and so on.

[Patent document 1] JP-A No.2003-91630

DISCLOSURE OF THE INVENTION

Now, in the case of merchandise that encompasses various brands and trademarks, it is a common practice to periodically perform a campaign, for preventing consumers from turning away to another brand thereby inducing the consumers to keep purchasing the same merchandise, or for urging the consumers to convert to a target brand.
The foregoing conventional art, however, does not suppose the turning away or conversion of the consumers with respect to the merchandise encompassing numerous brands and trademarks, and hence does not provide a method for simulating, for example, how much ROI would be expected from investment of promotional expenses, such as a campaign for a specific brand and the like.
These days the companies are continuously developing new products in response to the needs of the consumers and placing an extensive variety of merchandise in shops and stores, thus expanding severe competition for survival among the companies. Tastes and needs of individual consumers are also becoming more widely diversified, and the consumers are selectively purchasing the merchandise that fit their personal requirement, out of the extensive variety of merchandise. Also, under the flood of merchandise information originating from the highly information-oriented society, the consumers have trouble in finding out the information of the merchandise suitable to them out of the flooding information, and on the part of the companies, in turn, it has become necessary to grant distinctive features to each brand for differentiation from competitors' products or even their own products, to thereby establish meticulous strategies to acquire customers. To respond to the diversifying tastes and needs of the consumers, the companies providing merchandise and services are focusing on adopting the so-called one to one marketing method.
The one to one marketing method aims at recognizing the taste and sense of values of each single consumer so as to perform different approaches according to the individual needs, to thus acquire customers. This has been a common method since long among those merchants selling their merchandise through one to one deal to consumers, and today it is desired that the companies grow capable of carrying out this traditional deal through an efficiently automated system applicable to as many customers as possible.
The present invention has been conceived in view of the foregoing situation, with an object to provide a sales promotion support system capable of analyzing and evaluating a measure taken based on the one to one marketing method, thereby urging the customers to shift to the company's brand.
According to the present invention, there is provided a simulation apparatus that predicts an effect of sending out a direct mail of a sales promotion campaign of a product of a specific brand, comprising:

> a planned budget acceptance unit that accepts a planned budget of the campaign;
> a customer master table containing properties and turn-away probability of each customer;
> a condition acceptance unit that accepts a setting of a sending condition for sending the direct mail;
> a number of delivery applicable customers calculation unit that extracts the customers corresponding to the sending condition out of the customer master table, and calculates the number of delivery applicable customers to whom the direct mail may be sent;
> a number of delivery applicable customers presentation unit that presents the number of delivery applicable customers;

a planned number of delivery target customers acceptance unit that accepts a planned number of delivery target customers to whom the direct mail should be sent, with an upper limit being the number of delivery applicable customers;

an expected conversion rate acceptance unit that accepts an expected conversion rate based on the sending condition;

a number of conversion-expected customers calculation unit that calculates a number of conversion-expected customers, based on the planned number of delivery target customers and the expected conversion rate;

a unit value table that stores therein an earned value unit cost per customer, predetermined according to the properties of each brand of the product and indicating a value to be earned by a change made through the campaign on the brand that the customer primarily purchases;

an expected earned value calculation unit that looks up the unit value table, to acquire the earned value unit cost gained through the conversion to the specific brand, corresponding to the properties of the brand of the product to which the sending condition applies, thereby calculating the expected earned value based on the number of conversion-expected customers;

an expected ROI calculation unit that calculates an expected ROI based on the planned budget and the expected earned value; and

a prediction presentation unit that presents the expected earned value and the expected ROI.

Here, the properties of the customer include a brand currently primarily consumed by the customer and sex, age, area and so forth of the customer. In addition, the customer properties may include properties of each brand, for example, internal/external distinction indicating whether the brand is a proprietary product or a competitor's product (or company name), price category, taste category (for example whether the customer primarily consumes a product containing menthol), and tar content. The turn-away probability is determined in advance according to the properties of each customer. The turn-away probability may also be determined through a turn-away prediction based on a behavior model. The direct mail sending condition may include such properties, for example the internal/external distinction, price and taste category and tar content of the brand currently primarily consumed by the customer, and the area, sex and age of the customer. The condition acceptance unit is to accept at least one sending condition.

Here, the merchandise include those which encompass various brands and are selectively purchased based on taste and thinking of the customers continuously and periodically in a relatively short cycle, for example grocery items such as cigarettes and beverages, foodstuff, baby items such as paper diapers, powder milk and baby food, dog or cat food, sanitary items, quasi-drugs and drugs.

The number of conversion-expected customers calculation unit calculates the number of conversion-expected customers (= planned number of DM delivery target customers x expected conversion rate/100), based on the planned number of DM delivery target customers and the expected conversion rate. The expected earned value calculation unit calculates the expected earned value (= number of conversion-expected customers x unit value of the newly chosen brand) based on the number of conversion-expected customers. The expected ROI calculation unit calculates the expected ROI (Return On Investment), for example through (aggregated earned value - budget) ÷ budget × 100(%).

The present invention allows predicting, at the time of planning the direct mail campaign, the expected ROI with respect to different sending conditions according to the customer properties and thereby simulating the effect of the direct mail campaign, and therefore facilitates making a proper decision on the investment and establishing an efficient direct mail campaign based on the one to one marketing method which reflects the needs of each customer. Also, since the expected effect of the direct mail is expressly presented, a target can be easily set.

Also, the present invention allows specifying the delivery target customers to whom the direct mail should be sent based on the properties of each customer such as, in the case of cigarettes for example, the current primarily smoking brand, age, sex, area and so on, and simulating the effect of the campaign. Accordingly, the present invention allows providing, via direct mail, information appropriate for the needs of each customer based on the simulation result, to the customers carefully screened based on the customer information, which significantly increases the prospect of the campaign, compared with massively sending the direct mail to randomly extracted customers.

The simulation apparatus may further include a predicted turn-away rate storage unit that stores therein a predicted turn-away rate associated with a behavior pattern of the customer; a behavior pattern acquisition unit that acquires the behavior pattern of the customer; and a decision unit that compares the behavior pattern of the customer with a predetermined behavior pattern model thereby deciding the predicted turn-away rate, so that the simulation apparatus stores the predicted turn-away rate as the turn-away probability in the customer master table.

Here, the behavior pattern acquisition unit acquires the customer's behavior pattern through, for example, a result of a questionnaire research by a direct mail, an e-mail, a contribution form of a homepage or on the street, net-shopping records and a blog analysis result and the likes. The behavior pattern model may be updated based on the collected behavior patterns. Such structure allows automatically calculating the turn-away probability based on the customer's behavior pattern, and further adding customer information collected through a direct mail to the behavior pattern model.

According to the present invention, there is provided an effect measurement apparatus that measures an effect of a sales promotion campaign, executed through sending out a direct mail for a sales promotion campaign of a product of a specific brand under a predetermined sending condition and collecting answers to a questionnaire from customers, based on customer information including properties of the customer written on the returned postcard, comprising:

an acquisition unit that acquires the customer information automatically read out from the postcard;
an actual result database that acquires, from the customer information, conversion classification information indicating to which brand the customer has shifted his/her primary purchase as a result of the campaign, and accumulates such information of each customer;
a budget acceptance unit that accepts an input of a budget of the campaign;
a condition acceptance unit that accepts from the customer information a condition including the properties of the customer who is surveyed;
a number of sending postcards acceptance unit that accepts a number of postcards to be sent out with respect to each condition;
a number of newly converted customers calculation unit that calculates a number of newly converted customers based on the conversion classification information with respect to each condition;
a conversion rate calculation unit that calculates a conversion rate based on the number of newly converted customers and the number of postcards sent, with respect to each condition;
a unit value table that stores therein an earned value unit cost per customer, predetermined according to the properties of each brand of the product, and indicating a value to be earned by a change made through the campaign on the brand that the customer primarily purchases;
an earned value calculation unit that looks up the unit value table, to acquire the earned value unit cost gained through the conversion to the specific brand, corresponding to the properties of the brand of the product to which the sending condition applies, thereby calculating the earned value based on the number of newly converted customers;
a ROI calculation unit that calculates a ROI based on the budget and the earned value; and
an actual result presentation unit that presents the earned value and the ROI.

Forms of the sales promotion campaign include, for example, sending via direct mail an application form to an address selected from the customer information previously obtained and distributing the application form on the street, and a sample may accompany the application form. Alternatively, the application form may be attached to an advertisement in a magazine or a paper. The application form thus distributed may be collected by mail or on the street.

The conversion rate calculation unit calculates the conversion rate as: the number of newly converted customers ÷ the number of direct mails sent × 100(%).

The input unit automatically reads the results of the questionnaire from the application form through a scanner, for inputting the results. Alternatively, a questionnaire research may be carried out via a contribution form to be input on a homepage or e-mail, for receiving the result on line. In this case, for example a URL address for application, or an ID or a password for logging-in may be included in the direct mail to be sent out, so as to induce the customer to make access to the homepage and to input the answers to the questionnaire.

The questionnaire includes a question on the merchandise that the customer purchased before and after the campaign. The questionnaire may also include a question on the merchandise that the customer wishes to purchase in future. From such questions, it can be revealed whether there has been a change on the brand that the customer primarily purchases, in other words whether the customer has converted or turned away, as a result of the campaign. The questionnaire may also include a question for analyzing the customer's behavior pattern, so that the behavior pattern acquisition unit may acquire the result of such questionnaire, to thereby update the behavior pattern and further utilize that result for calculating the turn-away probability.

The effect measurement apparatus according to the present invention allows, upon sending out the direct mail to the customers selected through the one to one marketing method, automatically inputting the information of each customer from the returned direct mail, and calculating the ROI according to the predetermined value based on the accumulated customer information, thereby efficiently evaluating the outcome achieved by the campaign.

In the effect measurement apparatus, the actual result database accumulates, with respect to each customer, in association therewith, a delivery flag indicating whether the direct mail has been sent, a brand that the customer was purchasing before sending the direct mail, a brand that the customer has started purchasing after delivery of the direct mail, and a conversion flag indicating whether the customer has converted to a specific brand after delivery of the direct mail; and includes a first counting unit that counts out of the actual result database, with respect to each brand classification, a number of first type customers with the delivery flag indicating that the direct mail was sent and the conversion flag indicating that the customer has converted to the specific brand; a conversion rate by brand calculation unit that calculates, with respect to each brand classification, conversion rate based on the number of the first type customers and the number of direct mails sent; a second counting unit that counting out of the actual result database, with respect to each brand classification, a number of second type customers who were purchasing the specific brand before sending the direct mail; a specific brand purchase rate calculation unit that calculates, with respect to each brand classification, a purchase rate of an existing specific brand based on the number of the second type customers and the total number of customers in the actual result database; a real conversion rate calculation unit that calculates a real conversion rate achieved by sending the direct mails, based on the purchase rate and the conversion rate, with respect to each brand classification; a number of customers calculation unit that calculates, with respect to each brand classification, a number of customers gained by sending the direct mails, based on said number of postcards sent and the real conversion rate; an earned value calculation unit that calculates, with respect to each brand classification, an earned value based on the number of earned customers and the earned value unit cost; an effect calculation unit that calculates, with respect to each brand classification, an earned value per direct mail based on said number of postcards sent and said earned value; and a presentation unit that presents, with respect to each brand classification, the conversion rate, the purchase rate, the real conversion rate, the earned value, and the earned value per direct mail.

Such configuration allows examining the effect of the campaign executed through sending out the direct mails from the viewpoints of the conversion rate, the purchase rate, the real conversion rate, the earned value, and the earned value per DM, with respect to each brand classification. Taking these analysis results into consideration for subsequent campaign project facilitates circulating a PDS cycle, thereby performing efficient DM campaign.

According to the present invention, there is provided a sales promotion support system comprising a simulation apparatus and an effect measurement apparatus,
wherein the effect measurement apparatus includes:

a conversion rate accumulation unit that accumulates the conversion rate under each condition, from the customer information;
a norm value calculation unit that calculates a norm value of the accumulated conversion rate; and
a presentation unit that presents the norm value; and
an expected conversion rate acceptance unit of the simulation apparatus that accepts an expected conversion rate decided and input by a user looking up the norm value of the conversion rate presented by the presentation unit of the effect measurement apparatus.

Such configuration allows deciding the conversion rate under each condition in consideration of statistical resulting values based on the customer information massively collected through the DM campaign, thereby upgrading the calculation accuracy of the expected ROI.

According to the present invention, there is provided a sales promotion support system comprising a simulation apparatus and an effect measurement apparatus,
wherein a number of delivery applicable customers presentation unit and a prediction presentation unit of the simulation apparatus include a first display unit that displays a planning-phase screen;
an actual result presentation unit of the effect measurement apparatus includes a second display unit that displays an actual result screen; and
the planning-phase screen and the actual result screen employ a similar format.

Here, the first and the second display units may be a single display unit. The sales promotion support system thus configured employs a similar format in the display screen at the time of planning and the actual result display screen, thereby facilitating comparing the plan and the actual result, thus efficiently circulating the PDS (Plan-Do-See) cycle encompassing the planning, execution and examination phases.

According to the present invention, there is provided a program of predicting an effect of sending out a direct mail for a sales promotion campaign of a product of a specific brand, causing a computer including:

a customer master table including properties and turn-away probability of each customer; and
a unit value table that stores therein an earned value unit cost per customer, predetermined according to the properties of each brand of the product and indicating a value to be earned by a change made through the campaign on the brand that the customer primarily purchases; to perform as:

a planned budget acceptance unit that accepts a planned budget of the campaign;
a condition acceptance unit that accepts a setting of a sending condition for sending the direct mail;
a number of delivery applicable customers calculation unit that extracts the customers corresponding to the sending condition out of the customer master table, and calculates the number of delivery applicable customers to whom the direct mail may be sent;
a number of delivery applicable customers presentation unit that presents the number of delivery applicable customers;

a planned number of delivery target customers acceptance unit that accepts a planned number of delivery target customers to whom the direct mail should be sent, with an upper limit being the number of delivery applicable customers;

an expected conversion rate acceptance unit that accepts an expected conversion rate based on the sending condition;

a number of conversion-expected customers calculation unit that calculates a number of conversion-expected customers, based on the planned number of delivery target customers and the expected conversion rate;

an expected earned value calculation unit that looks up the unit value table, to acquire the earned value unit cost gained through the conversion to the specific brand, corresponding to the properties of the brand of the product to which the sending condition applies, thereby calculating the expected earned value based on the number of conversion-expected customers;

an expected ROI calculation unit that calculates an expected ROI based on the planned budget and the expected earned value; and

a prediction presentation unit that presents the expected earned value and the expected ROI.

According to the present invention, there is provided a program of measuring an effect of a sales promotion campaign, executed through sending out a direct mail for a sales promotion campaign of a product of a specific brand under a predetermined sending condition and collecting answers to a questionnaire from customers, based on customer information including properties of the customer written on the returned postcard, causing a computer including:

an actual result database that acquires, from the customer information, conversion classification information indicating to which brand the customer has shifted his/her primary purchase as a result of the campaign, and accumulates such information of each customer; and

a unit value table that stores therein an earned value unit cost per customer, predetermined according to the properties of each brand of the product and indicating a value to be earned by a change made through the campaign on the brand that the customer primarily purchases; to perform as:

an acquisition unit that acquires the customer information automatically read out from the postcard;

a budget acceptance unit that accepts an input of a budget of the campaign;

a condition acceptance unit that accepts from the customer information a condition including the properties of the customer who is surveyed;

a number of sending postcards acceptance unit that accepts a number of postcards to be sent out with respect to each condition;

a number of newly converted customers calculation unit that calculates a number of newly converted customers based on the conversion classification information with respect to each condition;

a conversion rate calculation unit that calculates a conversion rate based on the number of newly converted customers and the number of postcards sent, with respect to each condition;

an earned value calculation unit that looks up the unit value table, to acquire the earned value unit cost gained through the conversion to the specific brand, corresponding to the properties of the brand of the product to which the sending condition applies, thereby calculating the earned value based on the number of newly converted customers;

a ROI calculation unit that calculates a ROI based on the budget and the earned value; and

an actual result presentation unit that presents the earned value and the ROI.

Regarding the foregoing description on the structure of the present invention, it is to be noted that any optional combination of the foregoing constituents, as well as any conversion of the expressions of the present invention among a method, apparatus, system, recording media and computer program are effectively included in the scope of the present invention.

Thus, the present invention provides a sales promotion support system that enables analyzing and evaluating a measure taken based on the one to one marketing method, thereby urging the customers to shift to the company's brand.

BRIEF DESCRIPTION OF THE DRAWINGS

The foregoing and other objects, features and advantages will become more apparent through the following description on exemplar embodiments and the accompanying drawings specified here below.

Fig. 1 is a block diagram for explaining an outline of a sales promotion support system according to an embodiment of the present invention;

Fig. 2 is a schematic function block diagram showing a configuration of a DM campaign simulation apparatus according to the embodiment;

Fig. 3 is a block diagram showing an example of a hardware configuration of the DM campaign simulation apparatus shown in Fig. 2;

Fig. 4 is a diagram showing an example of a structure of a planning-phase information database shown in Fig. 2;

Fig. 5 is a diagram showing an example of a planning-phase screen displayed by a planning-phase screen display unit in the DM campaign simulation apparatus shown in Fig. 2;

Fig. 6 is a diagram showing an example of a structure of a customer master table of the DM campaign simulation apparatus shown in Fig. 2;

Fig. 7 is a diagram showing an example of a structure of a brand table in the DM campaign simulation apparatus shown in Fig. 2;

Fig. 8 is a diagram showing an example of a structure of a newly chosen brand unit value table in the DM campaign simulation apparatus shown in Fig. 2;

Fig. 9 is a flowchart showing an example of an operation of the DM campaign simulation apparatus shown in Fig. 2;

Fig. 10 is a schematic function block diagram showing a configuration of the sales promotion support system including the DM campaign effect measurement apparatus according to the embodiment;

Figs. 11 is a diagram showing an example of a structure of an actual result information database in the DM campaign effect measurement apparatus shown in Fig. 10;

Fig. 12 is a diagram showing an example of an actual result screen displayed by an actual result display unit in the DM campaign effect measurement apparatus shown in Fig. 10;

Fig. 13 is a flowchart showing an example of an operation of the DM campaign measurement apparatus shown in Fig. 10;

Fig. 14 is a schematic function block diagram showing a configuration of an effect measurement apparatus according to the embodiment of the present invention;

Fig. 15 is a diagram showing an example of a structure of a customer information storage unit in the DM campaign effect measurement apparatus shown in Fig. 14;

Fig. 16 is a diagram showing an example of a structure of a conversion information storage unit in the DM campaign effect measurement apparatus shown in Fig. 14;

Fig. 17 is a diagram showing an example of a conversion information screen displayed by a conversion information display unit in the DM campaign effect measurement apparatus shown in Fig. 14;

Fig. 18 is a flowchart showing an example of an operation of the DM campaign effect measurement apparatus shown in Fig. 14;

Fig. 19 is a diagram showing an example of a campaign effect screen displayed by a conversion information display unit in the DM campaign effect measurement apparatus shown in Fig. 14;

Fig. 20 is an example of a display that appears upon activating a DM simulation tool, according to an embodiment of the present invention;

Fig. 21 is an example of a display that appears on an update confirmation message screen of the DM simulation tool shown in Fig. 20; and

Fig. 22 is an example of a display that appears on an area modification/deletion screen of the DM simulation tool shown in Fig. 20.

## BEST MODE FOR CARRYING OUT THE INVENTION

Hereunder, embodiments of the present invention will be described referring to the drawings. In all the drawings, same constituents are given identical reference numerals, and the description thereof will not be repeated.

[First embodiment]

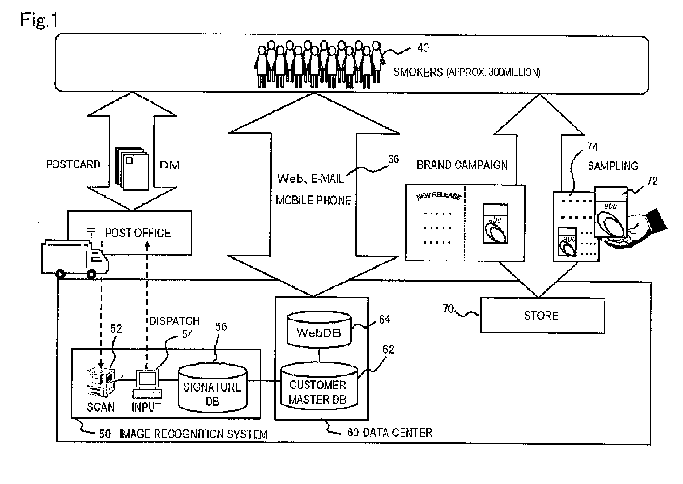

Fig. 1 is a block diagram for explaining an outline of a sales promotion support system according to an embodiment of the present invention. Hereunder, cigarettes will be employed as the example of the merchandise to be sold. The cigarette is particularly appropriate as the example, because of including numerous brands and being selectively purchased based on taste and philosophy of the customers continuously and periodically in a relatively short cycle.

The respective cigarette companies sometimes execute a campaign for sales promotion of the merchandise, for example by sending out a direct mail (DM) to smokers 40 selected out of pre-registered customer information to provide a questionnaire or the like, inducing the smokers to respond to the questionnaire with an added value such as a lottery or a privilege, collecting the responses, and thereby researching whether a change has been made with a primarily smoking brand as a result of the campaign. The collected postcards are read out with a scanner 52, so as to acquire the customer information through an image recognition system 50 operated by a computer 54, and to accumulate the information in the signature database 56. Here, the customer information includes, for example, properties such as the primarily smoking brand, before and after the campaign, sex, age and area.

The DM includes a questionnaire, in addition to a column to put down the name, year and date of birth, address, phone number, mail address and so forth of the customer. Although the customer information includes private information such as the name, address and phone number, in the following embodiment it suffices to extract the properties information of the customer including the age calculated from the year and date of birth, sex, area provided from the address, and answers to the questionnaire.

Examples of questions in the questionnaire may include an average daily consumption of the cigarettes, firmness of decision on the cigarette to be purchased (approx. seven grades may be specified for selection by the customer in advance, such as "always decided in advance", "half of the times decided, the rest undecided" and "always undecided"), the brand in the case of "decided" and smoking period of that brand (whether under or over one year, or how many years), a previous primarily smoking brand, whether that brand contains menthol, a brand that the customer may wish to smoke in future and the extent of anxiety (such as "very anxious to buy", "not so much" and "not interested at all"), so that the customer answers with numerical numbers. Causing the customer to use numerals facilitates the scanner 52 of the image recognition system 50 to read out the returned postcard.

Also, the application postcard 74 may be distributed with a sample 72 at a shop 70 and collect the response on site or by post, thereby acquiring and accumulating likewise the customer information. The customer information in the signature database 56 is then accumulated in a customer master database 62 of a data center 60.

Further, the campaign may be executed, not only by the direct mail, but by delivering the questionnaire through a contribution form on a homepage on a web or e-mail 66, thereby acquiring contributed or returned information, accumulating that information on a web database 64, and then integrating the data with the customer master database 62 for accumulation. The customer master database 62 may also accumulate therein information obtained through presumption of the customer's behavior model and the like based on an on-line purchase history, information written in a blog and so forth.

Then an analysis may be preformed based on the information accumulated in the customer master database 62 with respect to each customer, and ROI and other data resulting from the campaign may be calculated, to thereby measure the effect of the campaign and establish a subsequent campaign project, thus executing sales promotion utilizing the scheme of the one to one marketing that reflects the needs of each customer.

In the present invention, the sales promotion support system includes an image recognition center, a simulation apparatus that predicts an effect of sending out a direct mail for a sales promotion campaign of a product of a specific brand, and an effect measurement apparatus that measures the effect of the campaign.

Firstly, DM campaign simulation apparatus according to the embodiment of the present invention will be described here below.

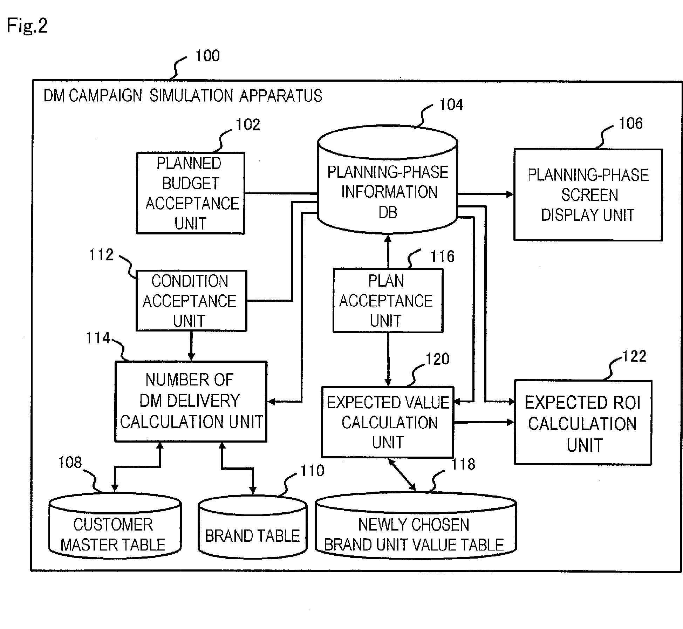

Fig. 2 is a schematic function block diagram showing a configuration of the DM campaign simulation apparatus 100 according to the embodiment. The simulation apparatus (DM campaign simulation apparatus 100) according to the embodiment of the present invention serves to predict an effect of sending out a direct mail for a sales promotion campaign of a product of a specific brand, and includes a planned budget acceptance unit (planned budget acceptance unit 102) that accepts a planned budget of the campaign, a customer master table (planning-phase information database 104) containing properties and turn-away probability of each customer, a condition acceptance unit (condition acceptance unit 112) that accepts a setting of a sending condition for sending the direct mail, a number of delivery applicable customers calculation unit (number of DM delivery calculation unit 114) that extracts the customers corresponding to the sending condition out of the customer master table, and calculates the number of delivery applicable customers to whom the direct mail may be sent, a number of delivery applicable customers presentation unit (planning-phase screen display unit 106) that presents the number of delivery applicable customers, a planned number of delivery target customers acceptance unit (plan acceptance unit 116) that accepts a planned number of delivery target customers to whom the direct mail should be sent, with an upper limit being the number of delivery applicable customers, an expected conversion rate acceptance unit (plan acceptance unit 116) that accepts an expected conversion rate based on the sending condition, a number of conversion-expected customers calculation unit (expected value calculation unit 120) that calculates a number of conversion-expected customers, based on the planned number of delivery target customers and the expected conversion rate, a unit value table (newly chosen brand unit value table 118) that stores therein an earned value unit cost per customer, predetermined according to the properties of each brand of the product and indicating a value to be earned by a change made through the campaign on the brand that the customer primarily purchases, an expected earned value calculation unit (expected value calculation unit 120) that looks up the unit value table, to acquire the earned value unit cost gained through the conversion to the specific brand, corresponding to the properties of the brand of the product to which the sending condition applies, thereby calculating the expected earned value based on the number of conversion-expected customers, an expected ROI calculation unit (expected ROI calculation unit 122) that calculates an expected ROI based on the planned budget and the expected earned value, and a prediction presentation unit (planning-phase screen display unit 106) that presents the expected earned value and the expected ROI.

To be more detailed, the DM campaign simulation apparatus 100 includes the planned budget acceptance unit 102, the planning-phase information database 104 (abbreviated as "planning-phase information DB" in the drawings), the planning-phase screen display unit 106, a customer master table 108, a brand table 110, the condition acceptance unit 112, the number of DM delivery calculation unit 114, the plan acceptance unit 116, the newly chosen brand unit value table 118, the expected value calculation unit 120, and the expected ROI calculation unit 122.

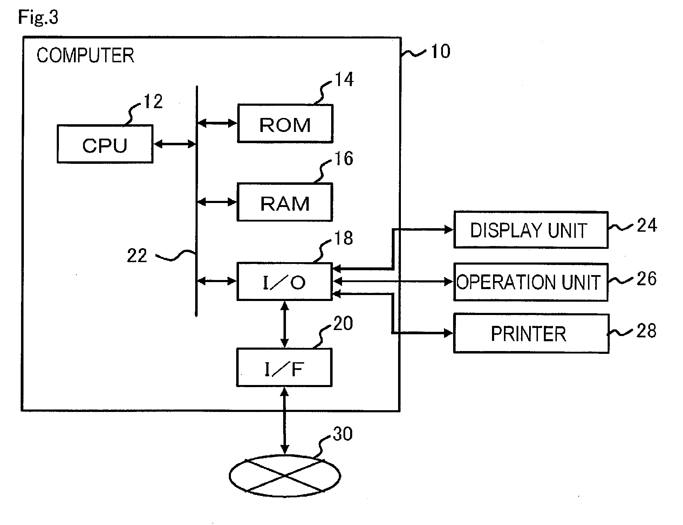

Here, the DM campaign simulation apparatus 100 according to the embodiment may be constituted of hardware shown in Fig. 3 as an example. The DM campaign simulation apparatus 100 is constituted of a computer 10, which may be for example a general-purpose personal computer. The computer 10 includes a CPU 12, a ROM 14, a RAM 16, an input/output unit (abbreviated as "I/O" in the drawings) 18, an external interface unit (abbreviated as "I/F" in the drawings) 20, and a bus 22 that connects those components. The computer 10 is connected to a network 30 via the external interface unit 20. The external input/output device of the computer 10 may include a display unit 24 such as a CRT monitor or a liquid-crystal display monitor, an operation unit 26 such as a keyboard, a mouse and a tablet, and a printer 28.

The ROM 14 stores therein a simulation program that causes the computer 10 to act as the DM campaign simulation apparatus 100, to be executed by the CPU 12. The ROM 14 may also include an effect measurement program that causes the computer 10 to act as the effect measurement apparatus, to be subsequently described, which is executed by the CPU 12. The CPU 12 controls the respective constituents of the computer 10, as well as an entirety of the apparatus.

The simulation program of the DM campaign simulation apparatus 100 according to this embodiment is a program of predicting an effect of sending out a direct mail for a sales promotion campaign of a product of a specific brand, and causes a computer (computer 10) including a customer master table (customer master table 108) including properties and turn-away probability of each customer, and a unit value table (newly chosen brand unit value table 118) that stores therein an earned value unit cost per customer, predetermined according to the properties of each brand of the product and indicating a value to be earned by a change made through the campaign on the brand that the customer primarily purchases, to perform as a planned budget acceptance unit (planned budget acceptance unit 102) that accepts a planned budget of the campaign, a condition acceptance unit (condition acceptance unit 112) that accepts a setting of a sending condition for sending the direct mail, a number of delivery applicable customers calculation unit (number of DM delivery calculation unit 114) that extracts the customers corresponding to the sending condition out of the customer master table, and calculates the number of delivery applicable customers to whom the direct mail may be sent, a number of delivery applicable customers presentation unit (planning-phase screen display unit 106) that presents the number of delivery applicable customers, a planned number of delivery target customers acceptance unit (plan acceptance unit 116) that accepts a planned number of delivery target customers to whom the direct mail should be sent, with an upper limit being the number of delivery applicable customers, an expected conversion rate acceptance unit (plan acceptance unit 116) that accepts an expected conversion rate based on the sending condition, a number of conversion-expected customers calculation unit (expected value calculation unit 120) that calculates a number of conversion-expected customers, based on the planned number of delivery target customers and the expected conversion rate, an expected earned value calculation unit (expected value calculation unit 120) that looks up the unit value table, to acquire the earned value unit cost gained through the conversion to the specific brand, corresponding to the properties of the brand of the product to which the sending condition applies, thereby calculating the expected earned value based on the number of conversion-expected customers, an expected ROI calculation unit (expected ROI calculation unit 122) that calculates an expected ROI based on the planned budget and the expected earned value, and a prediction presentation unit (planning-phase screen display unit 106) that presents the expected earned value and the expected ROI.

Referring again to Fig. 2, the planned budget acceptance unit 102 accepts an input of the planned budget of the campaign. The user may operate the operation unit 26 of the computer 10 of Fig. 3, so as to input the planned budget.

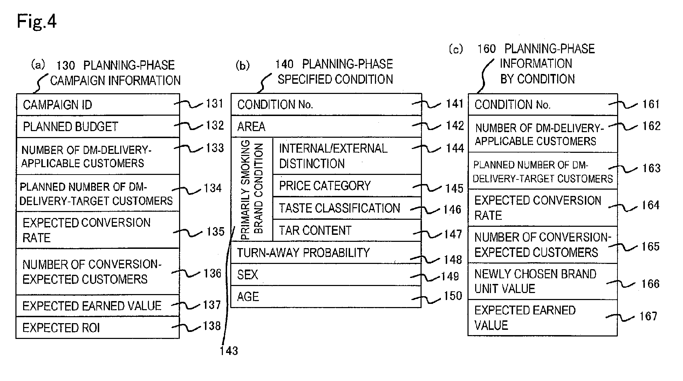

The planning-phase information database 104 contains information shown in Fig. 4, for example planning-phase campaign information 130, planning-phase specified condition 140, and planning-phase information by condition 160. As shown in Fig. 4(a), the planning-phase information database 104 stores therein, as the planning-phase campaign information 130, a planned budget 132, the number of DM-delivery-applicable customers 133, the planned number of DM-delivery-target customers 134, an expected conversion rate 135, a number of conversion-expected customers 136, an expected earned value 137, and an expected ROI 138, under each campaign ID 131.

The planning-phase information database 104 may also include a table (not shown) containing information such as the name, form, timing and number of applications of the campaign, with respect to each campaign ID 131.

As shown in Fig. 4(b), the planning-phase information database 104 stores therein, as the planning-phase specified condition 140, an area 142, a primarily smoking brand condition 143, turn-away probability 148, sex 149, and age 150 under each condition number 141. Further, the primarily smoking brand condition 143 includes internal/external distinction 144, price category 145, taste classification 146, and tar content 147.

As shown in Fig. 4(c), the planning-phase information database 104 stores therein, as the planning-phase information by condition 160, the number of DM-delivery-applicable customers 162, the planned number of DM-delivery-target customers 163, expected conversion rate 164, the number of conversion-expected customers 165, a newly chosen brand unit value 166, and an expected earned value 167, under each condition number 161.

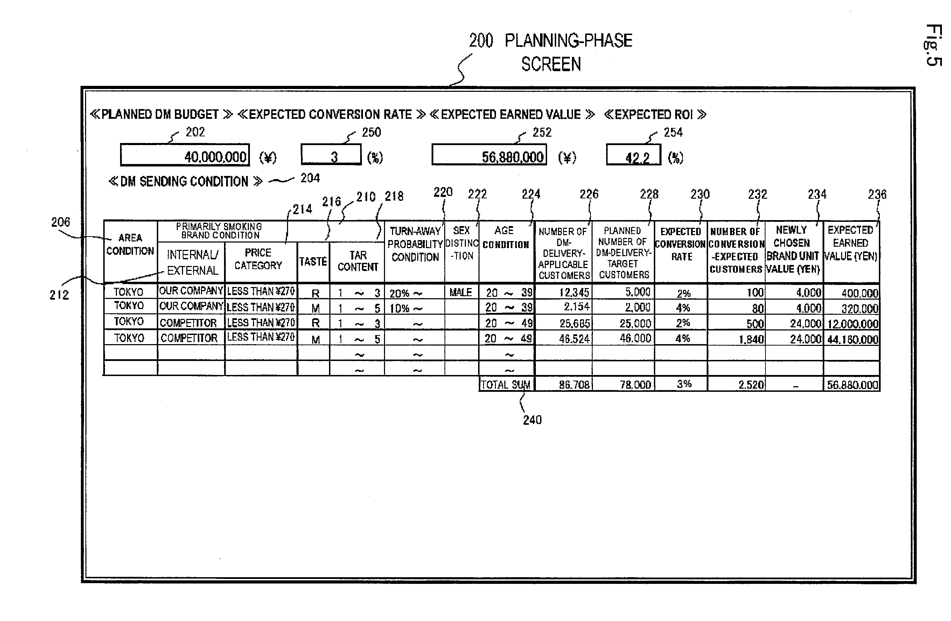

Referring again to Fig. 2, the planning-phase screen display unit 106 displays a planning-phase screen 200 shown in Fig. 5, on the display unit 24 of the computer 10 of Fig. 3. The planning-phase screen 200 may have its content edited into a format by a paper format editor (not shown) and output via the printer 28 of the computer 10. As shown in Fig. 5, the planning-phase screen 200 includes a planned DM budget input column 202, so that the amount of the planned budget, input thereto by the user via the operation unit 26 of the computer 10 of Fig. 3, is accepted by the planned budget acceptance unit 102 of Fig. 2, and stored in the planned budget 132 in the planning-phase campaign information 130 of Fig. 4(a).

The planning-phase screen 200 also includes a DM sending condition listing 204 for setting the condition of sending out the direct mail. The DM sending condition listing 204 further includes an area condition input column 206, a primarily smoking brand condition input column 210, a turn-away probability condition input column 220, a sex condition input column 222, an age condition input column 224. The primarily smoking brand condition input column 210 further includes an internal/external distinction input column 212, a price category input column 214, a taste classification input column 216, and a tar content input column 218.

In the planning-phase screen 200, at least one sending condition is to be set. In Fig. 5, four sending conditions are set. These sending conditions are input by the user to the respective columns via the operation unit 26 of the computer 10 of Fig. 3, to be accepted by the condition acceptance unit 112 shown in Fig. 2 to be described later and then stored in the respective items of the planning-phase specified condition 140 of Fig. 4(b).

Further, the planning-phase screen 200 includes a number of DM-delivery-applicable customers display column 226, a planned number of DM-delivery-target customers input column 228, an expected conversion rate input column 230, a number of conversion-expected customers display column 232, a newly chosen brand unit value display column 234, an expected earned value display column 236, a total sum display column 240, an expected conversion rate display column 250, an expected earned value display column 252, and an expected ROI display column 254.

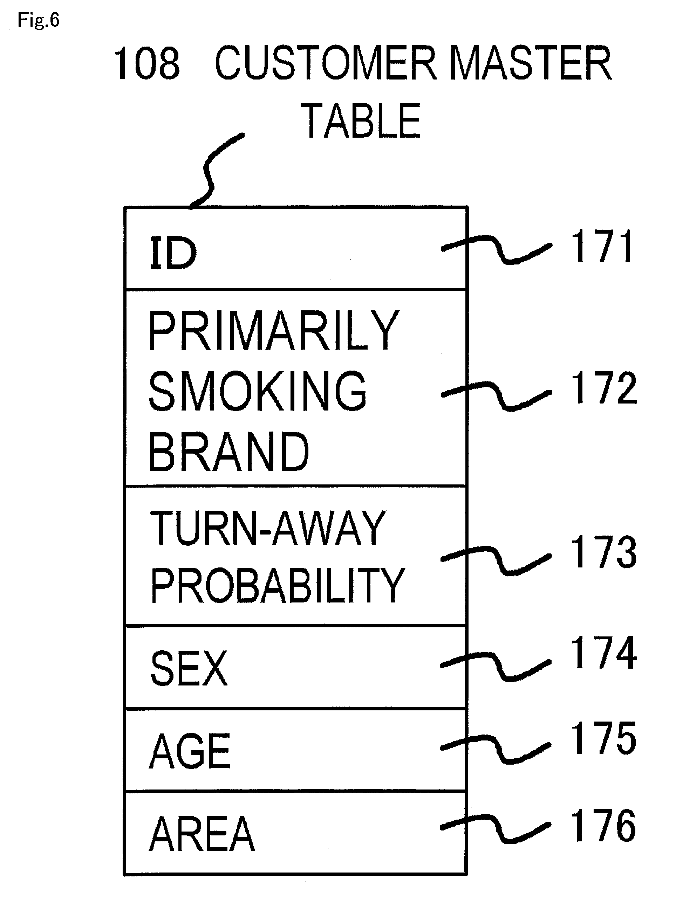

Referring again to Fig. 2, the customer master table 108 contains, as shown in Fig. 6, the information indicating the properties of the customer, such as a primarily smoking brand 172, turn-away probability 173, sex 174, age 175, and area 176 and the like, under each ID 171. It should be noted that the customer master table 108 does not contain private information that enables identifying the individual customer, and the address information necessary for sending the direct mail is to be separately stored.

The turn-away probability 173 is determined in advance according to the properties of each customer. Alternatively, the turn-away probability 173 may be determined through turn-away prediction based on a behavior model. For example, the DM campaign simulation apparatus 100 may further include a predicted turn-away rate storage unit (not shown) that stores therein a predicted turn-away rate associated with the customer's behavior pattern, a behavior pattern acquisition unit (not shown) that acquires the customer's behavior pattern, and a decision unit (not shown) that compares the customer's behavior pattern with a predetermined behavior pattern model, thereby deciding the predicted turn-away rate, so as to store the predicted turn-away rate that has been decided in the customer master table 108 as the turn-away probability 173.

Here, the behavior pattern acquisition unit acquires the customer's behavior pattern for example via a direct mail, e-mail, contribution form in a homepage, result of a questionnaire research on the street, a buying history in shopping on the Internet, and an analysis result of a blog. The behavior pattern model may be updated based on the collected behavior patterns. Such configuration allows automatically calculating the turn-away probability based on the customer's behavior pattern, and further incorporating the customer information collected via the direct mail and so on into the behavior pattern model.

Although the customer master table 108 is included in the DM campaign simulation apparatus 100 in Fig. 2, the present invention is not limited to such configuration. The customer master table 108 may be included in a customer master database stored in another computer via the network 30 shown in Fig. 3. The DM campaign simulation apparatus 100 may make access to such another computer via the network 30, to thereby acquire the customer information.

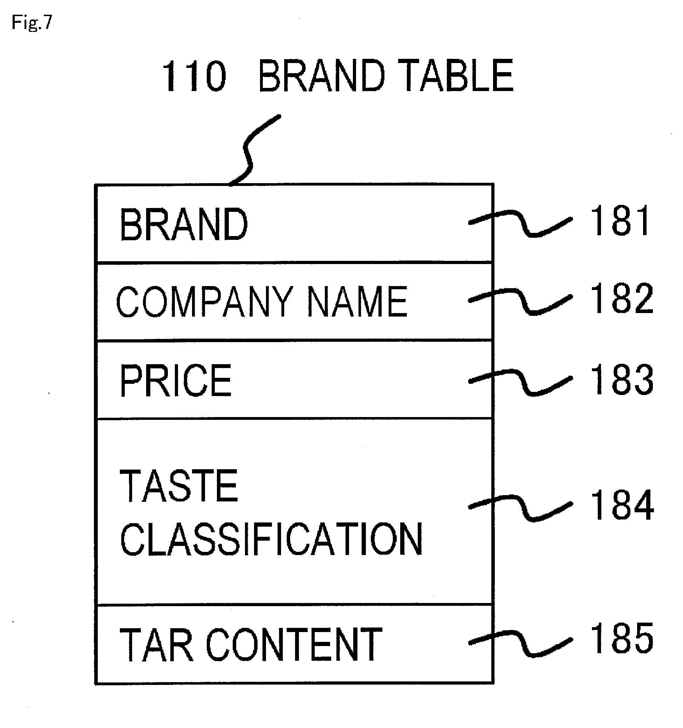

The brand table 110 contains, as shown in Fig. 7, a company name 182, a price 183, taste classification 184, and tar content 185, under each brand 181. The brand 181 may be represented by a code or a indicating the brand, or the name of the brand. The company name 182 may be represented by the name or code of the company selling that brand. The taste classification 184 may be represented by, for example, a taste classification code indicating a regular or menthol taste and the like.

Referring again to Fig. 2, the condition acceptance unit 112 accepts a setting of the sending condition of the direct mail, input by the user in the DM sending condition listing 204 of the planning-phase screen 200 of Fig. 5, via the operation unit 26 of the computer 10 of Fig. 3. The condition thus accepted is stored in the planning-phase specified condition 140 of Fig. 4(b).

The number of DM delivery calculation unit 114 makes access to the customer master table 108, to extract the customers to whom the sending condition applies, out of the customer master table 108, and calculates the number of customers to whom the direct mail may be sent, under each condition. The calculated number of delivery applicable customers is stored in the number of DM-delivery-applicable customers 162 in the planning-phase information by condition 160 of Fig. 4(c), and further displayed in the number of DM-delivery-applicable customers display column 226 in the planning-phase screen 200 of Fig. 5, by the planning-phase screen display unit 106.

The plan acceptance unit 116 accepts the setting of the planned number of delivery target customers to whom the direct mail should be sent, with an upper limit being the number of delivery-applicable customers input by the user in the planned number of DM-delivery-target customers input column 228 and the expected conversion rate input column 230 in the planning-phase screen 200 of Fig. 5, via the operation unit 26 of the computer 10 of Fig. 3, and also accepts an input of the expected conversion rate according to the sending condition. The accepted planned number of delivery target customers and the expected conversion rate are respectively stored in the number of DM-delivery-applicable customers 162 and the planned number of DM-delivery-target customers 163 of the planning-phase information by condition 160 of Fig. 4(c).

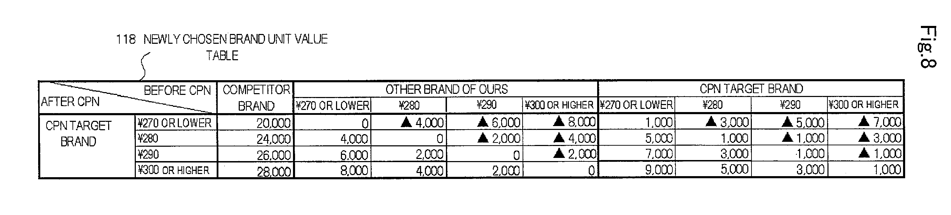

The newly chosen brand unit value table 118 serves to store therein a newly chosen brand unit value per customer, indicating a value to be earned by conversion of the primarily smoking brand made through the campaign. Fig. 8 specifies, as an example, the unit values to be earned per customer by the conversion made through the campaign (abbreviated as "CNP" in Fig. 8) on the primarily smoking brand to any of the campaign target brand (indicated as "CPN brand" in Fig. 8), with respect to types of the brand such as the internal/external distinction for proprietary products and competitor's products, and prices. For example, in the case where the customer has converted to the campaign target brand of ¥280.- from a competitor's brand, the newly chosen brand unit value is ¥24000.-. Also, if the customer has turned away from a proprietary brand of ¥290.- not involved in the campaign to the campaign target brand of ¥270.- or less, the newly chosen brand unit value is -¥6000.

Referring again to Fig. 2, the expected value calculation unit 120 calculates the number of conversion-expected customers from the planned number of delivery target customers and the expected conversion rate, by the following formula (1).

$$\texttt{Expected number of conversion-expected customers = planned}$$
$$\texttt{number of delivery target customers × expected conversion rate / 100}$$
$$\texttt{... (1)}$$

The number of conversion-expected customers thus calculated is stored in the number of conversion-expected customers 165 of the planning-phase information by condition 160 of Fig. 4(c), and displayed in the number of conversion-expected customers display column 232 in the planning-phase screen 200 of Fig. 5, by the planning-phase screen display unit 106. The expected value calculation unit 120 further looks up the newly chosen brand unit value table 118, and acquires the newly chosen brand unit values corresponding to the primarily smoking brand condition specified in the sending condition, to thereby display each such value in the newly chosen brand unit value display column 234 in the planning-phase screen 200 of Fig. 5, and store in the newly chosen brand unit value 166 in the planning-phase information by condition 160 of Fig. 4(c). Also, the expected value calculation unit 120 calculates the expected earned value from the number of conversion-expected customers and the newly chosen brand unit value, by the following formula (2).

$$\texttt{Expected earned value = number of conversion-expected}$$
$$\texttt{customers × newly chosen brand unit value ... (2)}$$

The expected earned value thus calculated is stored in the expected earned value 167 of the planning-phase information by condition 160 of Fig. 4(c) under each condition, and displayed in the expected earned value display column 236 in the planning-phase screen 200.

Also, as shown in the planning-phase screen 200 of Fig. 5, the number of DM-delivery-applicable customers display column 226, the planned number of DM-delivery-target customers input column 228, the expected conversion rate input column 230, the number of conversion-expected customers display column 232, and the expected earned value display column 236, which are input or calculated and displayed with respect to each condition, are respectively summed by an summing unit (not shown), and displayed in the corresponding columns of the total sum display column 240, as well as stored in the number of DM-delivery-applicable customers 133, the planned number of DM-delivery-target customers 134, the expected conversion rate 135, the number of conversion-expected customers 136, and the expected earned value 137 of the planning-phase campaign information 130 of Fig. 4(a), respectively. Further, the average of the expected conversion rate and the total sum of the expected earned value are also displayed in the expected conversion rate display column 250 and the expected earned value display column 252 of the planning-phase screen 200 of Fig. 5, respectively.

Referring again to Fig. 2, the expected ROI calculation unit 122 calculates the expected ROI from the expected earned value calculated as above and the planned budget, by the following formula (3) .

$$\texttt{Expected ROI (\%) = (expected earned value - planned budget)} \div$$

$$\texttt{planned budget} \times \texttt{100(\%) ... (3)}$$

The expected ROI thus calculated is displayed in the expected ROI display column 254 of the planning-phase screen 200 of Fig. 5 by the planning-phase screen display unit 106, and stored in the expected ROI 138 of the planning-phase campaign information 130 of Fig. 4(a).

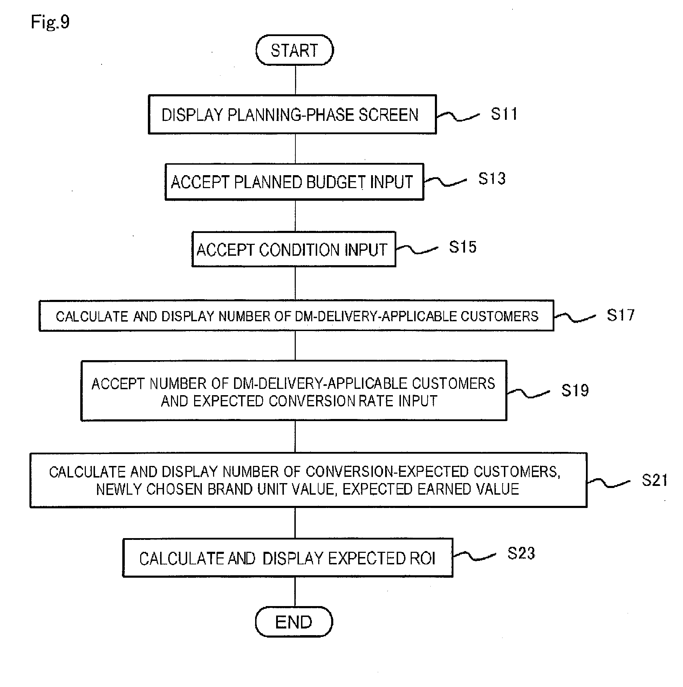

An operation of the DM campaign simulation apparatus 100 thus configured according to this embodiment will be described hereunder. Fig. 9 is a flowchart showing an example of an operation of the DM campaign simulation apparatus 100 according to this embodiment. The description will be made referring to Figs. 1 through 9 as under.

At first, information on object campaigns is registered in advance in the planning-phase information database 104, out of which a campaign to be simulated is designated, so that the planning-phase screen 200 corresponding to the designated campaign is displayed on the display unit 24 of the computer 10 (step S11).

The user inputs the planned budget to the planned DM budget input column 202 of the planning-phase screen 200 through the operation unit 26, and the planned budget acceptance unit 102 accepts the planned budget which has been input (step S13). The accepted planned budget is stored in the planned budget 132 of the planning-phase campaign information 130 of Fig. 4(a). Then the user inputs various conditions to the DM sending condition listing 204 of the planning-phase screen 200 through the operation unit 26, and the condition acceptance unit 112 accepts those conditions (step S15). The accepted conditions are individually stored in Fig. 4(b) under each condition.

The number of DM delivery calculation unit 114 then makes access to the customer master table 108, to extract the customers to whom the sending conditions apply out of the customer master table 108, and calculates the number of customers to whom the direct mail may be sent, with respect to each condition (step S17). The calculated number of delivery applicable customers is stored in the number of DM-delivery-applicable customers 162 of the planning-phase information by condition 160 of Fig. 4(c) under each condition, and displayed in the number of DM-delivery-applicable customers display column 226 of the planning-phase screen 200. Also, the summing unit calculates the total sum of the number of delivery applicable customers corresponding to each condition, which is displayed in the total sum display column 240 in the planning-phase screen 200.

Then the plan acceptance unit 116 accepts the setting of the planned number of delivery target customers to whom the direct mail should be sent and the input of the expected conversion rate, in the planned number of DM-delivery-target customers input column 228 and the expected conversion rate input column 230 of the planning-phase screen 200 under each condition, with an upper limit being the number of delivery applicable customers input by the user through the operation unit 26 (step S19). The accepted planned number of delivery target customers and the expected conversion rate are stored in the planned number of DM-delivery-target customers 163 and the expected conversion rate 164 of the planning-phase information by condition 160 of Fig. 4(c), under each condition. Further, the summing unit calculates the total sum of the planned number of delivery target customers corresponding to each condition and the average of the expected conversion rate, and these values are stored in the planned number of DM-delivery-target customers 134 and the number of conversion-expected customers 136 of the planning-phase campaign information 130 of Fig. 4(a), and displayed in the total sum display column 240 in the planning-phase screen 200. The average of the expected conversion rate is also displayed in the expected conversion rate display column 250 in the planning-phase screen 200.

Subsequently, the expected value calculation unit 120 then calculates by the foregoing formula (1) the number of conversion-expected customers from the planned number of delivery target customers and the expected conversion rate accepted at the step S19, and such value is stored in the number of conversion-expected customers 165 of the planning-phase information by condition 160 of Fig. 4(c) under each condition, and displayed in the number of conversion-expected customers display column 232 in the planning-phase screen 200. Also, the summing unit calculates the total sum of the number of conversion-expected customers, which is stored in the number of conversion-expected customers 136 of the planning-phase campaign information 130 of Fig. 4(a), and displayed in the total sum display column 240 in the planning-phase screen 200 (step S21).

Further, the expected value calculation unit 120 makes access to the newly chosen brand unit value table 118, and acquires the newly chosen brand unit value corresponding to the primarily smoking brand condition specified under each condition, to thereby display such value in the newly chosen brand unit value display column 234 in the planning-phase screen 200, and to store the value in the newly chosen brand unit value 166 of the planning-phase information by condition 160 of Fig. 4(c).

Then, the expected value calculation unit 120 calculates by the foregoing formula (2) the expected earned value from the number of conversion-expected customers and the newly chosen brand unit value, and stores such value in the expected earned value 167 of the planning-phase information by condition 160 of Fig. 4(c). Also, the summing unit calculates the total of the expected earned value, which is stored in the expected earned value 137 of the planning-phase campaign information 130 of Fig. 4(a), and displayed in the total sum display column 240 in the planning-phase screen 200 and the expected earned value display column 252.

The expected ROI calculation unit 122 then calculates by the foregoing formula (3) the expected ROI from the expected earned value calculated at the step S21 and the planned budget accepted at the step S13 (step S23). The calculated value is then stored in the expected ROI 138 of the planning-phase campaign information 130 of Fig. 4(a), and displayed in the expected ROI display column 254 in the planning-phase screen 200.

As described above, the DM campaign simulation apparatus 100 according to this embodiment allows predicting, at the time of planning the direct mail campaign, the expected ROI with respect to different sending conditions according to the customer properties and thereby simulating the effect of the direct mail campaign, and therefore facilitates making a proper decision on the investment and establishing an efficient direct mail campaign based on the one to one marketing method which reflects the needs of each customer. Also, since the expected effect of the direct mail is expressly presented, a target can be easily set.

This embodiment also allows specifying the delivery target customers to whom the direct mail should be sent based on the properties of each customer such as, in the case of cigarettes for example, the current primarily smoking brand, age, sex, area and so on, and simulating the effect of the campaign. Accordingly, the embodiment allows providing, via direct mail, information appropriate for the needs of each customer based on the simulation result, to the customers carefully screened based on the customer information, which significantly increases the prospect of the campaign, compared with massively sending the direct mail to randomly extracted customers.

Now, the effect measurement apparatus according to the embodiment of the present invention will be described hereunder.

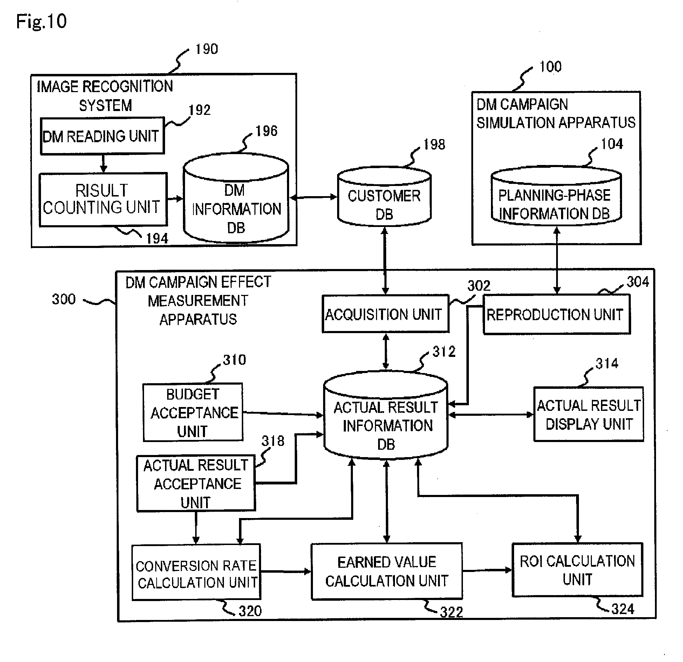

Fig. 10 is a schematic function block diagram showing a configuration of the sales promotion support system including the DM campaign effect measurement apparatus 300 according to the embodiment of the present invention. The effect measurement apparatus (DM campaign effect measurement apparatus 300) serves to measure an effect of a sales promotion campaign, executed through sending out a direct mail for a sales promotion campaign of a product of a specific brand under a predetermined sending condition and collecting answers to a questionnaire from customers, based on customer information including properties of the customer written on the returned postcard, and includes an acquisition unit (acquisition unit 302) that acquires the customer information automatically read out from the postcard, an actual result database (actual result information database 312) that acquires, from the customer information, conversion classification information indicating to which brand the customer has shifted his/her primary purchase as a result of the campaign, and accumulates such information of each customer, a budget acceptance unit (budget acceptance unit 310) that accepts an input of a budget of the campaign, a condition acceptance unit (reproduction unit 304) that accepts from the customer information a condition including the properties of the customer who is surveyed, a number of sending postcards acceptance unit (actual result acceptance unit 318) that accepts a number of postcards to be sent out with respect to each condition, a number of newly converted customers calculation unit (conversion rate calculation unit 320) that calculates a number of newly converted customers based on the conversion classification information with respect to each condition, a conversion rate calculation unit (conversion rate calculation unit 320) that calculates a conversion rate based on the number of newly converted customers and the number of postcards sent, with respect to each condition, a unit value table (newly chosen brand unit value table 118 of the DM campaign simulation apparatus 100) that stores therein an earned value unit cost per customer, predetermined according to the properties of each brand of the product, and indicating a value to be earned by a change made through the campaign on the brand that the customer primarily purchases, an earned value calculation unit (earned value calculation unit 322) that looks up the unit value table, to acquire the earned value unit cost gained through the conversion to the specific brand, corresponding to the properties of the brand of the product to which the sending condition applies, thereby calculating the earned value based on the number of newly converted customers, a ROI calculation unit (ROI calculation unit 324) that calculates a ROI based on the budget and the earned value, and an actual result presentation unit (actual result display unit 314) that presents the earned value and the ROI.

As described above, the DM campaign effect measurement apparatus 300 according to this embodiment may be attained through an effect measurement program executed by the CPU 12 of the computer 10 of Fig. 3. Thus, the effect measurement program for the DM campaign effect measurement apparatus 300 according to this embodiment is a program of measuring an effect of a sales promotion campaign, executed through sending out a direct mail for a sales promotion campaign of a product of a specific brand under a predetermined sending condition and collecting answers to a questionnaire from customers, based on customer information including properties of the customer written on the returned postcard, and the program causes a computer (computer 10) including an actual result database (actual result information database 312) that acquires, from the customer information, conversion classification information indicating to which brand the customer has shifted his/her primary purchase as a result of the campaign, and accumulates such information of each customer, and a unit value table (newly chosen brand unit value table 118) that stores therein an earned value unit cost per customer, predetermined according to the properties of each brand of the product and indicating a value to be earned by a change made through the campaign on the brand that the customer primarily purchases, to perform as an acquisition unit that acquires the customer information automatically read out from the postcard, a budget acceptance unit (budget acceptance unit 310) that accepts an input of a budget of the campaign, a condition acceptance unit (reproduction unit 304) that accepts from the customer information a condition including the properties of the customer who is surveyed, a number of sending postcards acceptance unit (actual result acceptance unit 318) that accepts a number of postcards to be sent out with respect to each condition, a number of newly converted customers calculation unit (conversion rate calculation unit 320) that calculates a number of newly converted customers based on the conversion classification information with respect to each condition, a conversion rate calculation unit (conversion rate calculation unit 320) that calculates a conversion rate based on the number of newly converted customers and the number of postcards sent, with respect to each condition, an earned value calculation unit (earned value calculation unit 322) that looks up the unit value table, to acquire the earned value unit cost gained through the conversion to the specific brand, corresponding to the properties of the brand of the product to which the sending condition applies, thereby calculating the earned value based on the number of newly converted customers, a ROI calculation unit (ROI calculation unit 324) that calculates a ROI based on the budget and the earned value, and an actual result presentation unit (actual result display unit 314) that presents the earned value and the ROI.

Referring again to Fig. 10, an image recognition system 190 includes a DM reading unit 192, a result counting unit 194, and a DM information database 196.

The DM reading unit 192 reads an image on the returned postcard with a scanner, and applies the acquired image to an OCR (Optical Character Reader), thereby acquiring the image in a form of character information.

The result counting unit 194 extracts necessary information out of the character information acquired by the DM reading unit 192, and stores the extracted information in the DM information database 196.

The DM information database 196 accumulates the customer information from the returned postcards.

The image recognition system 190 according to this embodiment is capable of automatically processing, for instance, a million postcards per day.

The customer information accumulated in the image recognition system 190 is further accumulated in a customer database 198. The customer database 198 contains customer properties information possessed by the pertinent company, and includes, for example, primarily smoking brand information, sex, age, place of residence, and the like, as well as various information such as answers to the questionnaire and past smoking history, with respect to each customer.

The DM campaign effect measurement apparatus 300 includes the acquisition unit 302, the reproduction unit 304, the budget acceptance unit 310, the actual result information database 312, the actual result display unit 314, the actual result acceptance unit 318, the conversion rate calculation unit 320, the earned value calculation unit 322, and the ROI calculation unit 324.

The DM campaign effect measurement apparatus 300 shown in Fig. 10 may also include a computer having the same configuration as the computer 10 of Fig. 3.

Here, although the DM campaign simulation apparatus 100 and the DM campaign effect measurement apparatus 300 are provided as separate components in this embodiment, the programs associated with the respective apparatus may be installed in the same computer 10, so that executing the respective programs may perform the both functions with a single apparatus. Hereunder, description will be made on the assumption that the same computer 10 is employed.

The acquisition unit 302 makes access to the customer database 198, to acquire necessary information from the customer database 198 and store the information in the actual result information database 312. Here, the acquisition unit 302 confirms newly chosen brand information of the customers involved in the campaign supposed to undergo the effect measurement, and extracts, with respect to each condition, upon finishing the campaign, the customers who have converted to the specific brand promoted in the campaign, aggregates the number of such customers, and stores that number in the actual result information database 312 as the number of newly converted customers. The actual result information database 312 will be described later.

The reproduction unit 304 reads out the information stored in the planning-phase information database 104 of the DM campaign simulation apparatus 100, and reproduces that information in the actual result information database 312.

The budget acceptance unit 310 accepts an input of the budget of the campaign. The user may manipulate the operation unit 26 of the computer 10, thus inputting the planned budget.

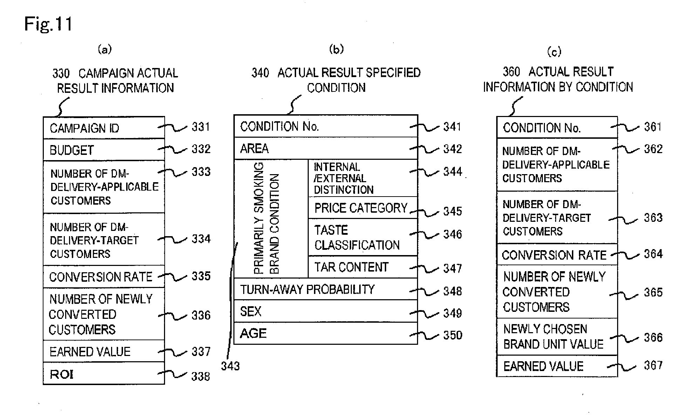

The actual result information database 312 contains information shown in Fig. 11, for example, campaign actual result information 330, an actual result specified condition 340, and actual result information by condition 360. As shown in Fig. 11(a), the actual result information database 312 stores therein, as the campaign actual result information 330, under each campaign ID 331, the budget 332, the number of DM-delivery applicable customers 333, the number of DM-delivery-target customers 334, the conversion rate 335, the number of newly converted customers 336, the earned value 337, and the ROI 338.

The actual result information database 312 may also contain a table (not shown) containing information such as the name, form, timing of conduct, and number of applications of the campaign, under each campaign ID.

As shown in Fig. 11(b), the actual result information database 312 stores therein, as the actual result specified condition 340, under each condition number 341, the area 342, the primarily smoking brand condition 343, the turn-away probability 348, the sex 349, and the age 350. Further, the primarily smoking brand condition 343 includes the internal/external distinction 344, the price category 345, the taste classification 346, and the tar content 347. Thus, the actual result specified condition 340 of the actual result information database 312 has the same structure as the planning-phase specified condition 140 of the planning-phase information database 104 of Fig. 4(b), and the reproduction unit 304 reproduces the data stored in the planning-phase specified condition 140, in the actual result information database 312.

As shown in Fig. 11(c), the actual result information database 312 contains, as the actual result information by condition 360, under each condition number 361, the number of DM-delivery-applicable customers 362, the number of DM-delivery-target customers 363, the conversion rate 364, the number of newly converted customers 365, the newly chosen brand unit value 366, and the earned value 367. Here, the number of DM-delivery-applicable customers 362 and the newly chosen brand unit value 366 of the actual result information by condition 360 are the same data as the number of DM-delivery-applicable customers 162 and the expected conversion rate 164 of the planning-phase information by condition 160 of the planning-phase information database 104 in the DM campaign simulation apparatus 100, reproduced by the reproduction unit 304.

In addition, as already stated, the number of newly converted customers 365 stores therein the total number of the customers who have converted the primarily smoking brand, acquired by the acquisition unit 302 from the customer database 198.

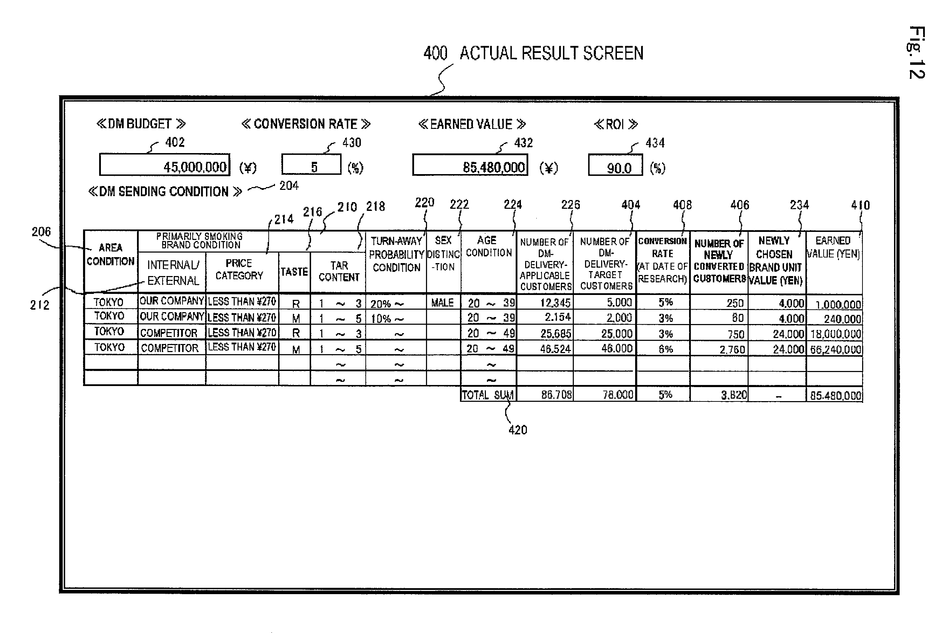

Referring again to Fig. 10, the actual result display unit 314 displays the actual result screen 400 shown in Fig. 12, on the display unit 24 of the computer 10. Here, the actual result screen 400 may be edited by the paper format editor into a paper format, and output via the printer 28 of the computer 10. As shown in Fig. 12, the actual result screen 400 includes a DM budget input column 402, so that the amount of the budget input to the DM budget input column 402 by the user through the operation unit 26 of the computer 10 is accepted by the budget acceptance unit 310, and stored in the budget 332 in the campaign actual result information 330 of Fig. 11(a).

The actual result screen 400 also includes the DM sending condition listing 204, which is the same as the DM sending condition listing 204 in the planning-phase screen 200 of Fig. 5. Here, the conditions in the actual result specified condition 340 of Fig. 11(b) are read out and displayed in the DM sending condition listing 204 in the actual result screen 400. Further, the conditions in the DM sending condition listing 204 may be modified in each column by the user through the operation unit 26 of the computer 10. In this case, the DM campaign effect measurement apparatus 300 includes the condition acceptance unit 112 which is the same as that of the DM campaign simulation apparatus 100, and the modified condition is accepted by the condition acceptance unit 112, so that the actual result specified condition 340 of the actual result information database 312 is modified, according to the accepted modification.

Further, the actual result screen 400 includes the number of DM-delivery-applicable customers display column 226 and the newly chosen brand unit value display column 234 which are the same as those in the planning-phase screen 200, such that the number of DM-delivery-applicable customers 362 and the newly chosen brand unit value 366 of the actual result information by condition 360 of Fig. 11(c) are read out and respectively displayed.

When the condition is modified as stated above, the data of the number of DM-delivery-applicable customers 362 and the newly chosen brand unit value 366 are respectively recalculated and updated. For example, the DM campaign effect measurement apparatus 300 may include the DM delivery calculation unit 114, the customer master table 108, the brand table 110, the newly chosen brand unit value table 118, and the expected value calculation unit 120, so that the DM delivery calculation unit 114 extracts the customer corresponding to the modified sending condition from the customer master table 108, and calculates the number of DM-delivery-applicable customers with respect to each condition. The calculated number of delivery applicable customers is stored in the number of DM-delivery-applicable customers 362 of Fig. 11(c) and displayed in the number of DM-delivery-applicable customers display column 226 in the actual result screen 400. Also, the expected value calculation unit 120 looks up the newly chosen brand unit value table 118, to thereby acquire a newly chosen brand unit value corresponding to the primarily smoking brand condition of the modified sending condition, and to update the newly chosen brand unit value 366 of Fig. 11(c) as well as the display in the newly chosen brand unit value display column 234 in the actual result screen 400.

Further, the actual result screen 400 includes the number of DM-delivery-target customers input column 404, the number of newly converted customers display column 406, the earned value display column 410, the total sum display column 420, the conversion rate display column 430, the earned value display column 432, and the ROI display column 434.

As described above, it is preferable to use a similar format for the actual result screen 400, to that of the planning-phase screen 200 of Fig. 5. Applying thus a similar format to the planning-phase display screen and the actual result display screen allows clearly comparing the plan and the actual result, thus facilitating efficient circulation of the PDS cycle encompassing the planning, execution and examination phases.

Referring again to Fig. 10, the actual result acceptance unit 318 accepts, in the number of DM-delivery-target customers input column 404 in Fig. 12, the number of delivery target customers to whom the direct mail was sent, with an upper limit being the number of delivery applicable customers input by the user via the operation unit 26 of the computer 10. The accepted number of delivery target customers is stored in the number of DM-delivery-applicable customers 362 in the actual result information by condition 360 of Fig. 11(c).

The conversion rate calculation unit 320 calculates the conversion rate from the number of delivery target customers and the number of newly converted customers, by the following formula (4).

$$\text{Conversion rate(\%)} = \text{number of newly converted customers} \div$$

$$\text{number of delivery target customers} \times 100(\%) \dots (4)$$

The conversion rate thus calculated is stored in the conversion rate 364 in the actual result information by condition 360 of Fig. 11(c), and displayed in the conversion rate display column 408 in the actual result screen 400 of Fig. 12, by the actual result display unit 314. At this stage, the number of newly converted customers stored in the number of newly converted customers 365 in the actual result information by condition 360 of Fig. 11(c) is also displayed in the number of newly converted customers display column 406 in the actual result screen 400.

The earned value calculation unit 322 calculates the earned value from the number of newly converted customers and the newly chosen brand unit value, by the following formula (5).

$$\text{Earned value} = \text{number of newly converted customers} \times \text{newly}$$

$$\text{chosen brand unit value} \dots (5)$$

The earned value thus calculated is stored in the earned value 367 in the actual result information by condition 360 of Fig. 11(c) under each condition, and displayed in the earned value display column 410 in the actual result screen 400.

Also, as shown in the actual result screen 400 of Fig. 12, the number of DM-delivery-applicable customers display column 226, the number of DM-delivery-target customers input column 404, the conversion rate display column 408, the number of newly converted customers display column 406, the newly chosen brand unit value display column 234, and the earned value display column 410, which are displayed under each condition, are respectively summed by a summing unit (not shown) and displayed in the corresponding column in the total sum display column 420, and stored in the number of DM-delivery-applicable customers 333, the number of DM-delivery-target customers 334, the conversion rate 335, the number of newly converted customers 336, and the earned value 337 in the campaign actual result information 330 of Fig. 11(a), respectively. Also, the average of the conversion rate and the total sum of the earned value are displayed in the conversion rate display column 430 and the earned value display column 432 in the actual result screen 400, respectively.

Referring again to Fig. 10, the ROI calculation unit 324 calculates the ROI from the earned value calculated as above and the budget, by the following formula (6).

$$ROI(\%) = (earned\ value - budget) \div budget \times 100(\%) \ \ldots\ (6)$$

The ROI thus calculated is displayed in the ROI display column 434 in the actual result screen 400 by the actual result display unit 314, and stored in the ROI 338 in the campaign actual result information 330 of Fig. 11(a).

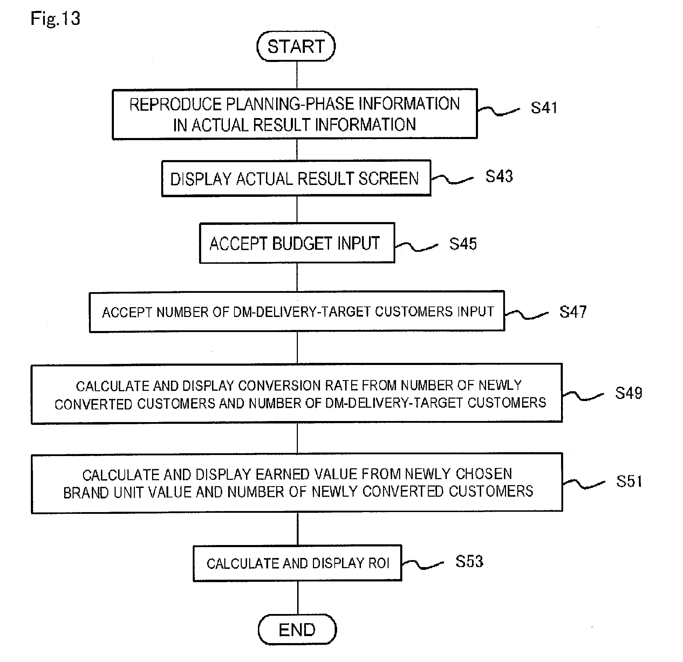

An operation of the DM campaign effect measurement apparatus 300 configured as above according to this embodiment will be described here below. Fig. 13 is a flowchart showing an example of an operation of the DM campaign measurement apparatus 300 according to this embodiment. Hereunder, the description will be made referring to Fig. 3, and Figs. 10 to 13.

Firstly, the reproduction unit 304 reproduces the data of the planning-phase specified condition 140 from the planning-phase information database 104 of the DM campaign simulation apparatus 100, in the actual result specified condition 340 in the actual result information database 312 (step S41). The reproduction unit 304 also reproduces the data of the number of DM-delivery-applicable customers 162 and the newly chosen brand unit value 166 from the planning-phase information database 104 of the DM campaign simulation apparatus 100, in the number of DM-delivery-applicable customers 362 and the newly chosen brand unit value 366 in the actual result information by condition 360 of the actual result information database 312. Further, the acquisition unit 302 extracts the customers who have converted to a specific brand involved in the campaign from the customer database 198 and sums the number of newly converted customers with respect to each condition specified in the actual result specified condition 340, and then stores such data in the number of newly converted customers 365 in the actual result information by condition 360 in the actual result information database 312.

Then the actual result display unit 314 displays the actual result screen 400 on the display unit 24 of the computer 10 (step S43). At this stage, preferably the planning-phase information relayed from the planning-phase information database 104 of the DM campaign simulation apparatus 100 is already displayed in the DM sending condition listing 204, the number of DM-delivery-applicable customers display column 226, and the newly chosen brand unit value display column 234 in the actual result screen 400. Also, preferably the total sum of the number of DM-delivery-applicable customers display column 226 calculated by the summing unit is also displayed.

Then the user inputs the budget in the DM budget input column 402 in the actual result screen 400 through the operation unit 26, and the budget acceptance unit 310 accepts the input budget (step S45). The accepted budget is stored in the budget 332 in the campaign actual result information 330 of Fig. 11(a). The user then inputs the number of DM-delivery-target customers in the number of DM-delivery target customers input column 404 in the actual result screen 400 through the operation unit 26, and the actual result acceptance unit 318 acceptance the number of DM-delivery-target customers (step S47). The accepted number of DM-delivery-target customers is stored in the number of DM-delivery-target customers 363 of Fig. 11(c). Further, the summing unit calculates the total sum of the delivery target customers corresponding to the respective conditions, and the total sum is stored in the number of DM-delivery-target customers 334 in the campaign actual result information 330 of Fig. 11(a), and displayed in the total sum display column 420 in the actual result screen 400.

Then, the conversion rate calculation unit 320 calculates the conversion rate from the number of DM-delivery-target customers and the number of newly converted customers by the formula (4), and stores the rate in the conversion rate 364 in the actual result information by condition 360 of Fig. 11(c) (step S49). Further, the summing unit calculates the average of the conversion rate, and the average is stored in the conversion rate 335 in the campaign actual result information 330 of Fig. 11(a), and displayed in the total sum display column 420 and the conversion rate display column 430 in the actual result screen 400.

In turn, the earned value calculation unit 322 calculates the earned value from the number of newly converted customers 365 and the newly chosen brand unit value 366 in the actual result information by condition 360 of Fig. 11(c) by the formula (5), and stores the value in the earned value 367 of Fig. 11(c) (step S51). Also, the summing unit calculates the total sum of the earned value, and the total sum is stored in the earned value 337 of Fig. 11(a) and displayed in the total sum display column 420 and the earned value display column 432 in the actual result screen 400.

Then the ROI calculation unit 324 calculates the ROI from the earned value calculated at the step S51 and the budget accepted at the step S45, by the formula (6) (step S53). The ROI is then stored in the ROI 338 in the campaign actual result information 330 of Fig. 11(a), and displayed in the ROI display column 434 in the actual result screen 400.

As described above, the DM campaign effect measurement apparatus 300 according to this embodiment allows sending out the direct mail to the customers selected based on the one to one marketing method, automatically inputting the information of each customer from the returned direct mail, and calculating the ROI according to values specified in advance based on the accumulated customer information, thereby efficiently evaluating the outcome of the campaign.

[Second embodiment]

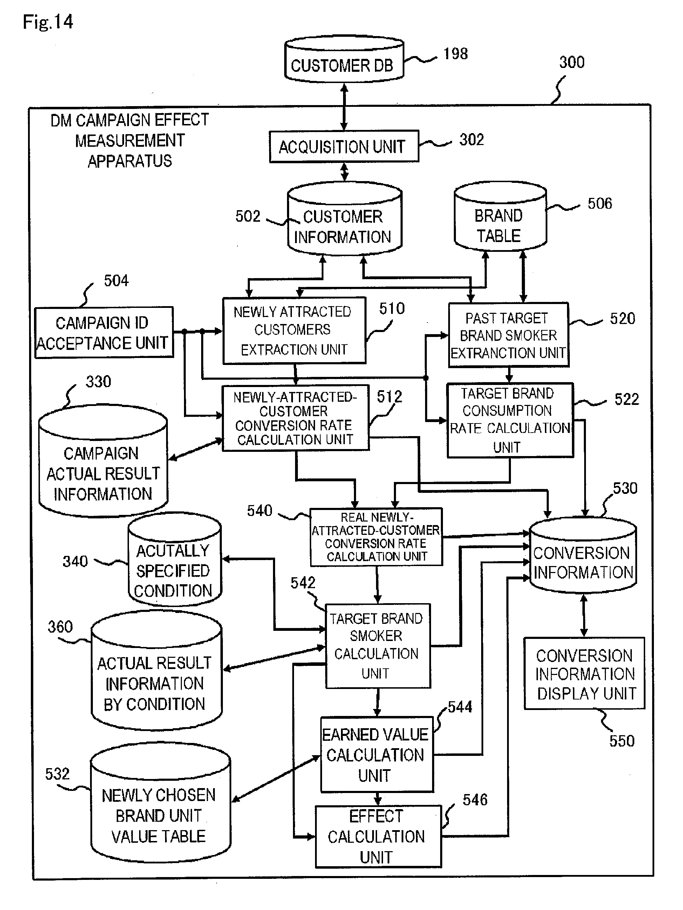

Fig. 14 is a schematic function block diagram showing a configuration of an effect measurement apparatus according to the embodiment of the present invention. The DM campaign effect measurement apparatus 300 according to this embodiment includes, in addition to the components of the DM campaign effect measurement apparatus 300 according to the foregoing embodiment, a customer information storage unit (represented as "customer information" in the drawings) 502, a campaign ID acceptance unit 504, a brand table 506, a newly attracted customer extraction unit 510, a newly-attracted-customer conversion rate calculation unit 512, a past target brand smoker extraction unit 520, a target brand consumption rate calculation unit 522, a conversion information storage unit (represented as "conversion information" in the drawings) 530, a newly chosen brand unit value table 532, a real newly-attracted-customer conversion rate calculation unit 540, a target brand smokers calculation unit 542, an earned value calculation unit 544, an effect calculation unit 546, and a conversion information display unit 550.

The DM campaign effect measurement apparatus 300 according to this embodiment is different from the foregoing embodiment also in that detailed breakdown of the conversion structure of the primarily smoking brand before and after delivery of the direct mail is presented as the campaign effect.

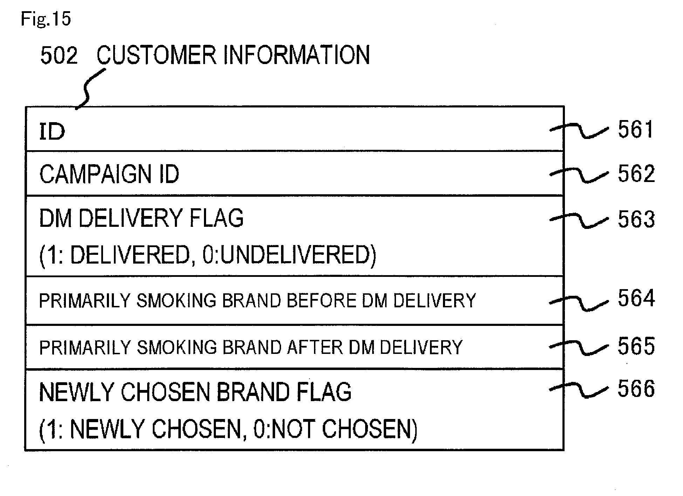

The customer information storage unit 502 includes, as shown in Fig. 15, an ID 561, a campaign ID 562, a DM delivery flag 563, a primarily smoking brand before DM 564, a primarily smoking brand after DM delivery 565, and a newly chosen brand flag 566, with respect to each customer.

Here, the DM delivery flag 563 is set as 1 for customer to whom the DM was sent, and 0 for customers to whom the DM was not sent, in the campaign ID 562. In the primarily smoking brand before DM 564, information of the brand that the customer was primarily consuming before sending the DM is stored, and information of the brand newly chosen by the customer after delivery of the DM is stored in the newly chosen brand 565. The brand information is denoted, for example, by a brand code. The newly chosen brand flag 566 is set as 1 in the case where a specific brand involved in the campaign has been newly chosen as a primarily smoking brand by the customer, and 0 in a negative case.

The acquisition unit 302 extracts, from the customer database 198, information on whether the DM was sent with respect to each campaign and the brand information before and after delivery of the DM, with respect to each customer, and stores the necessary information in the customer information storage unit 502. For example, the acquisition unit 302 sets the DM delivery flag 563 according to the information on whether the DM was sent, and stores the primarily smoking brand before DM 564 and the newly chosen brand 565 and sets the newly chosen brand flag 566 according to the brand information before and after delivery of the DM.

Referring again to Fig. 14, the campaign ID acceptance unit 504 accepts selection of the campaign to be analyzed. For example, the user may select the campaign by inputting the campaign ID or selecting a campaign name out of a list, through the operation unit 26 of the computer 10.

The brand table 506 has the same structure as the brand table 110 of the DM campaign simulation apparatus 100 according to the foregoing embodiment. Detailed description thereof will not be repeated.

The newly attracted customer extraction unit 510 makes access to the customer information storage unit 502, and extracts the customers with setting the newly chosen brand flag 566 out of the customer information corresponding to the campaign ID accepted by the campaign ID acceptance unit 504, with respect to each of predetermined classifications. Here, the classification may be made based on company names such as A-company and B-company, C-company and other companies, and also based on the taste, for example regular taste smokers and menthol smokers, with respect to each company. The newly-attracted-customer conversion rate calculation unit 512 aggregates the number of customers extracted by the newly attracted customer extraction unit 510, and acquires the number of DM-delivery-target customers 334 corresponding to the campaign ID from the campaign actual result information 330, to thereby calculate the newly-attracted-customer conversion rate by the following formula (7).

Newly-attracted-customer conversion rate(%) = number of newly attracted customers ÷ number of DM-delivery-target customers × 100(%) ... (7)

The newly-attracted-customer conversion rate thus calculated is stored in the conversion information storage unit 530, which will be described later.

The past target brand smoker extraction unit 520 makes access to the customer information storage unit 502, and extracts the customers whose primarily smoking brand before DM 564 includes the specific brand involved in the campaign, out of the customer information corresponding to the campaign ID accepted by the campaign ID acceptance unit 504, with respect to each classification. The target brand consumption rate calculation unit 522 aggregates the past target brand smoker extracted by the past target brand smoker extraction unit 520 thus to obtain the number of past target brand smokers, and acquires the number of DM-delivery-target customers 334 corresponding to the campaign ID from the campaign actual result information 330, to thereby calculate the target brand consumption rate by the following formula (8), with respect to each classification.

$$\text{Primary consumption rate}(\%) = \text{number of past target brand}$$
$$\text{smokers} \div \text{number of DM-delivery-target customers} \times 100(\%) \,\ldots\, (8)$$

The target brand consumption rate thus calculated is stored in the conversion information storage unit 530, which will be described later.

The newly chosen brand unit value table 532 has the same structure as the newly chosen brand unit value table 118 of the DM campaign simulation apparatus 100 according to the foregoing embodiment.

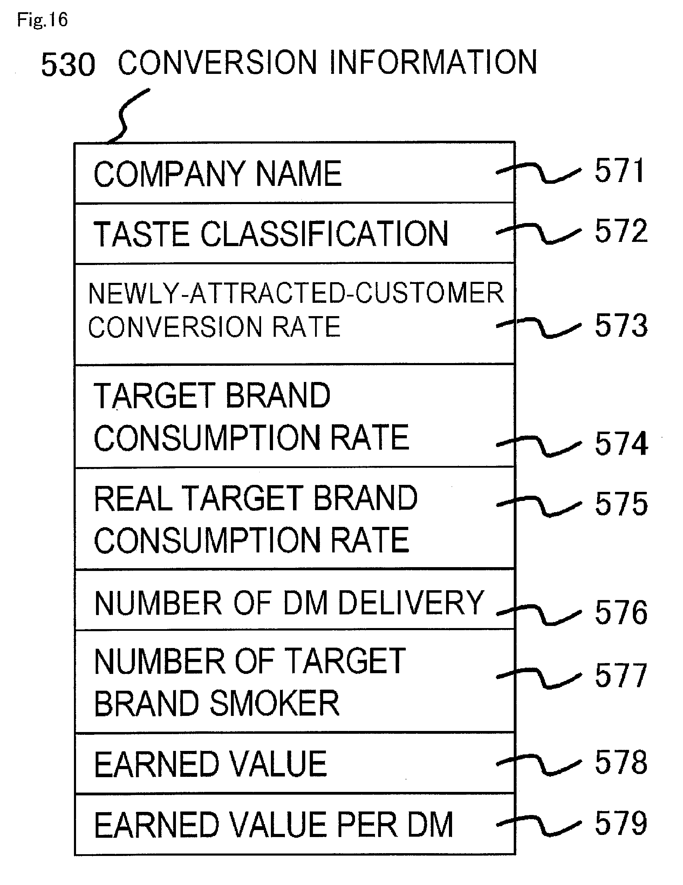

The conversion information storage unit 530 contains, as shown in Fig. 16, the company name 571, the taste classification 572, the newly-attracted-customer conversion rate 573, the target brand consumption rate 574, the real target brand consumption rate 575, the number of DM delivery 576, the number of target brand smokers 577, the earned value 578, and the earned value per DM 579. The newly-attracted-customer conversion rate after delivery of the DM calculated by the newly-attracted-customer conversion rate calculation unit 512 is stored in the newly-attracted-customer conversion rate 573, and the target brand consumption rate before delivery of the DM calculated by the target brand consumption rate calculation unit 522 is stored in the target brand consumption rate 574.

Referring again to Fig. 14, the real newly-attracted-customer conversion rate calculation unit 540 calculates the newly-attracted-customer conversion rate achieved by the DM effect, from the newly-attracted-customer conversion rate and the target brand consumption rate calculated by the newly-attracted-customer conversion rate calculation unit 512 and the target brand consumption rate calculation unit 522, by the following formula (9) with respect to each classification.

$$\text{Real newly-attracted-customer conversion rate}(\%) = \text{newly-}$$
$$\text{attracted-customer conversion rate} - \text{target brand consumption rate} \,\ldots$$
$$(9)$$

The real newly-attracted-customer conversion rate thus calculated is stored in the real target brand consumption rate 575 in the conversion information storage unit 530 of Fig. 16, under each classification.

The target brand smokers calculation unit 542 extracts the condition corresponding to the foregoing classification out of the actual result specified condition 340, and acquires the number of DM-delivery-target customers 363 to whom the condition applies according to the actual result information by condition 360, to thereby aggregate the number of DM-delivery-target customers with respect to each classification. The number of target brand smokers by the DM effect is calculated from the aggregated number of DM-delivery-target customers and the real newly-attracted-customer conversion rate calculated by the real newly-attracted-customer conversion rate calculation unit 540, by the following formula (10) with respect to each classification.

$$\text{Number of target brand smokers} = \text{number of DM-delivery-target}$$
$$\text{customers} \times \text{real newly-attracted-customer conversion rate} / 100 \,\ldots$$
$$(10)$$

The number of target brand smokers thus calculated is stored in the number of target brand smokers 577 in the conversion information storage unit 530 of Fig. 16, under each classification.

The earned value calculation unit 544 makes access to the newly chosen brand unit value table 532, and acquires the corresponding newly chosen brand unit value according to the classification. For example, in the case where the brand involved in the campaign is ¥270.- or less, the newly chosen brand unit value gained by conversion from a competitor's brand is ¥20000.-. Then the earned value calculation unit 544 calculates the earned value from the newly chosen brand unit value and the number of target brand smokers calculated by the target brand smokers calculation unit 542, by the following formula (11) with respect to each classification.

$$\text{Earned value} = \text{newly chosen brand unit value} \times \text{number of}$$

$$\text{target brand smokers} \ldots (11)$$

The earned value thus calculated is stored in the earned value 578 in the conversion information storage unit 530 of Fig. 16.

The effect calculation unit 546 calculates the earned value per DM of the earned value calculated by the earned value calculation unit 544, from the number of DM-delivery-target customers acquired by the target brand smokers calculation unit 542 by the following formula (12) with respect to each classification.

$$\text{Earned value per DM} = \text{earned value} / \text{the number of DM-}$$

$$\text{delivery-target customers} \ldots (12)$$

The earned value per DM thus calculated is stored in the earned value per DM 579 in the conversion information storage unit 530 of Fig. 16.

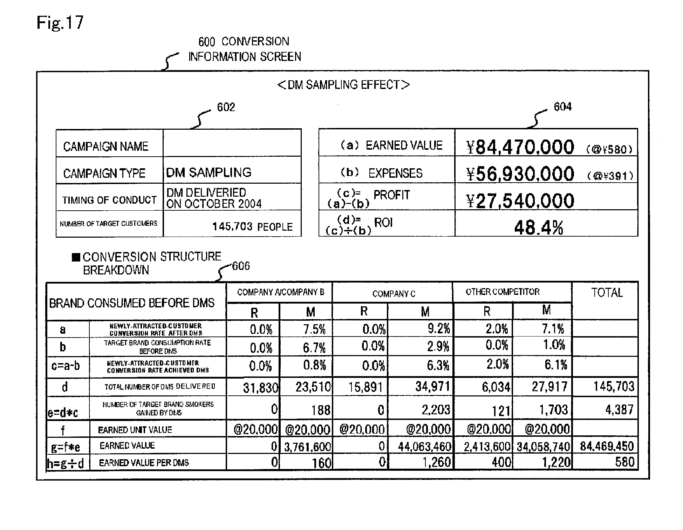

Fig. 17 is an example of a conversion information screen 600 displayed on the display unit 24 of the computer 10 by the conversion information display unit 550, in the DM campaign effect measurement apparatus 300 according to this embodiment. The conversion information screen 600 includes the information that indicates an effect attained by a DM sampling (hereinafter abbreviated as "DMS"), with respect to each campaign. For example, the conversion information screen 600 includes a campaign information column 602, a campaign effect column 604, and a conversion information listing 606. Here, the conversion information screen 600 may also be edited into a paper format by the paper format editor, and output via the printer 28 of the computer 10.

The campaign information column 602 displays the information on the campaign such as the name, form, timing of conduct and the number of customers to whom the DM was sent, acquired from the actual result information database 312. The campaign effect column 604 displays the information of the campaign such as the earned value, expense, profit and ROI. Here, the expense is, though not referred to in the foregoing passages, supposed to be stored in advance in the actual result information database 312 as information. The profit is the value calculated by subtracting the expense from the earned value.

The conversion information listing 606 displays, under each classification, a newly-attracted-customer conversion rate after the DMS delivery, a target brand consumption rate before the DMS delivery, a newly-attracted-customer conversion rate achieved by the DMS, the total number of DMS delivered, the number of target brand smokers gained by the DMS effect, the earned value unit cost, the earned value, and the earned value per DMS. For each of those items, the newly-attracted-customer conversion rate 573, the target brand consumption rate 574, the real target brand consumption rate 575, the number of DM delivery 57.6 and the number of target brand smokers 577 of the corresponding classification in the conversion information storage unit 530, the newly chosen brand unit value of the corresponding classification in the newly chosen brand unit value table 532, and the earned value 578 and the earned value 579 per DM in the conversion information storage unit 530 are respectively read out, and displayed in the conversion information listing 606.

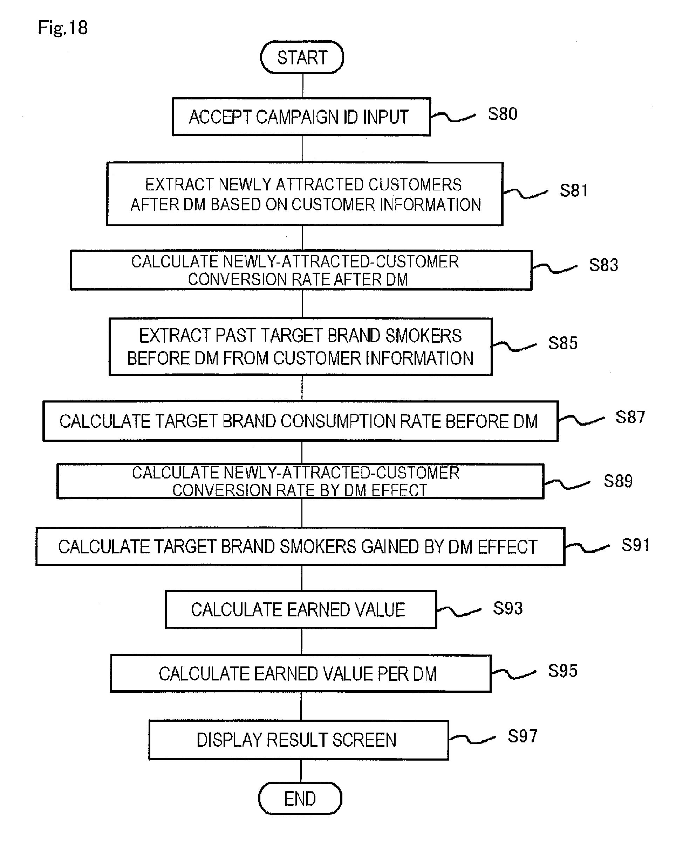

An operation of the DM campaign effect measurement apparatus 300 configured as above will be described hereunder. Fig. 18 is a flowchart showing an example of an operation of the DM campaign effect measurement apparatus 300 according to this embodiment.

An operation in the DM campaign effect measurement apparatus 300, through which the conversion information display unit 550 displays the conversion information screen 600 on the display unit 24 of the computer 10 for measuring the effect of the DM campaign, will now be described.

Firstly, the user manipulates the operation unit 26 of the computer 10 to thereby input the campaign ID and so on, thus selecting the campaign which is the object of the effect measurement. The campaign ID acceptance unit 504 accepts the campaign ID (step S80). Then the newly attracted customer extraction unit 510 makes access to the customer information storage unit 502, and extracts the customers set by the newly chosen brand flag 566 with respect to predetermined classifications, out of the customer information corresponding to the campaign ID accepted by the campaign ID acceptance unit 504 at the step S80. (step S81).

The newly-attracted-customer conversion rate calculation unit 512 then aggregates the number of customers extracted by the newly attracted customer extraction unit 510 at the step S81 and acquires the number of DM-delivery-target customers 334 corresponding to the campaign ID from the campaign actual result information 330, to thereby calculate the newly-attracted-customer conversion rate by the formula (7) with respect to each classification (step S83). The calculated newly-attracted-customer conversion rate is stored in the newly-attracted-customer conversion rate 573 in the conversion information storage unit 530 of Fig. 16.

Then the past target brand smoker extraction unit 520 makes access to the customer information storage unit 502, and extracts the customers whose primarily smoking brand before DM 564 includes the specific brand involved in the campaign, out of the customer information corresponding to the campaign ID accepted by the campaign ID acceptance unit 504 at the step S80, with respect to each classification (step S85).

In turn, the target brand consumption rate calculation unit 522 aggregates the past target brand smoker extracted by the past target brand smoker extraction unit 520 at the step S85 thus obtaining the number of past target brand smokers, and acquires the number of DM-delivery-target customers 334 corresponding to the campaign ID from the campaign actual result information 330, to thereby calculate the target brand consumption rate by the formula (8), with respect to each classification (step S87). The calculated target brand consumption rate is stored in the target brand consumption rate 574 in the conversion information storage unit 530 of Fig. 16.

Then the real newly-attracted-customer conversion rate calculation unit 540 calculates the real newly-attracted-customer conversion rate achieved by the campaign effect by the formula (9) with respect to each classification, from the newly-attracted-customer conversion rate and the target brand consumption rate calculated by the newly-attracted-customer conversion rate calculation unit 512 and the target brand consumption rate calculation unit 522 at the step S83 and the step S87, respectively (step S89). The calculated real newly-attracted-customer conversion rate is stored in the real target brand consumption rate 575 in the conversion information storage unit 530 of Fig. 16.

The target brand smokers calculation unit 542 then extracts the condition corresponding to the foregoing classification from the actual result specified condition 340, and acquires the number of DM-delivery-target customers 363 to whom the condition applies, from the actual result information by condition 360, to thereby aggregate the number of DM-delivery-target customers under each classification. Then the number of target brand smokers achieved by the campaign effect is calculated by the formula (10) with respect to each classification, from the aggregated number of DM-delivery-target customers and the real newly-attracted-customer conversion rate calculated by the real newly-attracted-customer conversion rate calculation unit 540 (step S91). The calculated number of target brand smokers is stored in the number of target brand smokers 577 in the conversion information storage unit 530 of Fig. 16, under each classification.

Then the earned value calculation unit 544 makes access to the newly chosen brand unit value table 532, and acquires the corresponding newly chosen brand unit value according to the classification, and calculates the earned value from the newly chosen brand unit value and the number of target brand smokers calculated by the number of target brand smokers calculation unit 542, by the formula (11) with respect to each classification (step S93). The calculated earned value is stored in the earned value 578 in the conversion information storage unit 530 of Fig. 16.

The effect calculation unit 546 calculates the earned value per DM based on the earned value calculated by the earned value calculation unit 544 at the step S93, by the formula (12) from the number of DM-delivery-target customers acquired by the number of target brand smokers calculation unit 542 at the step S91, with respect to each classification (step S95). The calculated earned value per DM is stored in the earned value 579 in the conversion information storage unit 530 of Fig. 16.

Each information stored in the conversion information storage unit 530 at the foregoing steps is displayed as the conversion information screen 600 of Fig. 17 on the display unit 24 of the computer 10, by the conversion information display unit 550 (step S97).

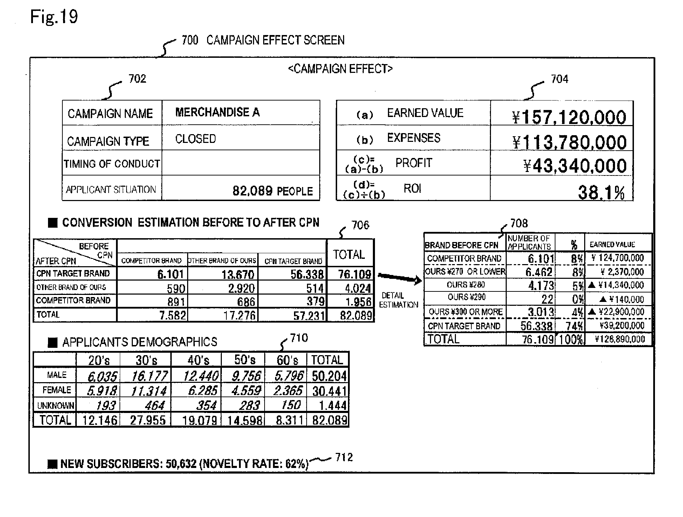

Also, the conversion information display unit 550 may display a campaign effect screen 700 shown in Fig. 19, as another example of the screen showing the analysis result of the effect measurement. Here, the campaign effect screen 700 may be edited by the paper format editor into a paper format, and output via the printer 28 of the computer 10.

The campaign effect screen 700 includes, for example, a campaign information column 702, a campaign effect column 704, a conversion estimation listing 706, a detail estimation listing 708, an applicant demographics 710, and the number of new subscribers 712.

The campaign information column 702 displays the information on the campaign such as the name, form, timing of conduct and the number of customers to whom the DM was sent, acquired from the actual result information database 312. The campaign effect column 704 displays the information of the campaign such as the earned value, expense, profit and ROI. Here, the expense is, though not referred to in the foregoing passages, supposed to be stored in advance in the actual result information database 312 as information. The profit is the value calculated by subtracting the expense from the earned value.

The conversion estimation listing 706 shows an estimation of the brand conversion that takes place through the campaign. For example, Fig. 19 shows that 6,101 customers have converted to the campaign target brand (abbreviated as "CPN target brand" in the drawings) after the campaign, out of those customers who used to primarily consume a competitor's brand before the campaign. It is also shown that 379 customers have converted to a competitor's brand after the campaign, out of the customers who used to primarily consume the relevant CPN target brand before the campaign.

The detail estimation listing 708 shows the details of the conversion situation of the customers who have converted to the relevant CPN target brand after the campaign, and the earned value. Since the newly chosen brand unit value of the earned value differs depending on the brand that was primarily consumed before the campaign as stated above (Ref. Fig. 8), the detailed number of conversion customers (represented by "applicants" in the drawings) and the earned value, with respect to each primarily smoking brand.

The applicant demographics 710 are a listing classifying the applicants of the campaign by the properties such as sex and age group, and the like. A counting unit (not shown) aggregates the data from the customer information accumulated in the customer database 198, and the aggregated value is displayed by the conversion information display unit 550. The number of new subscribers 712 represents the number of customers newly registered in the customer database 198 as a result of the relevant campaign.

As described above, the DM campaign effect measurement apparatus 300 according to this embodiment allows evaluating the effect of the campaign executed through sending out the direct mails, based on the conversion rate, purchase rate, real conversion rate, earned value, earned value per DM and so forth, with respect to each brand classification. Incorporating such analysis result into subsequent campaign projects facilitates efficiently circulating the PDS cycle and thus executing an efficient DM campaign.

Although the embodiments of the present invention have been described referring to the drawings, it is to be understood that those embodiments are merely exemplary, and that various other configurations may be adopted. It is a matter of course that the acquisition and utilization of the information regarding the customers should be legally performed.

For example, in the sales promotion support system according to the foregoing embodiments, the effect measurement apparatus (DM campaign effect measurement apparatus 300) may include a conversion rate accumulation unit (not shown) that accumulates the conversion rate under each condition, from the customer information, a norm value calculation unit (not shown) that calculates a norm value of the accumulated conversion rate, and a presentation unit (not shown) that presents the norm value; and an expected conversion rate acceptance unit (plan acceptance unit 116) of the simulation apparatus (DM campaign simulation apparatus 100) that accepts the expected conversion rate decided and input by the user looking up the norm value of the conversion rate presented by the presentation unit of the effect measurement apparatus (DM campaign effect measurement apparatus 300).

Such configuration allows deciding the conversion rate under each condition in consideration of statistically processed actual values based on the customer information massively collected through the DM campaign, thereby upgrading the calculation accuracy of the expected ROI.

[Working example]

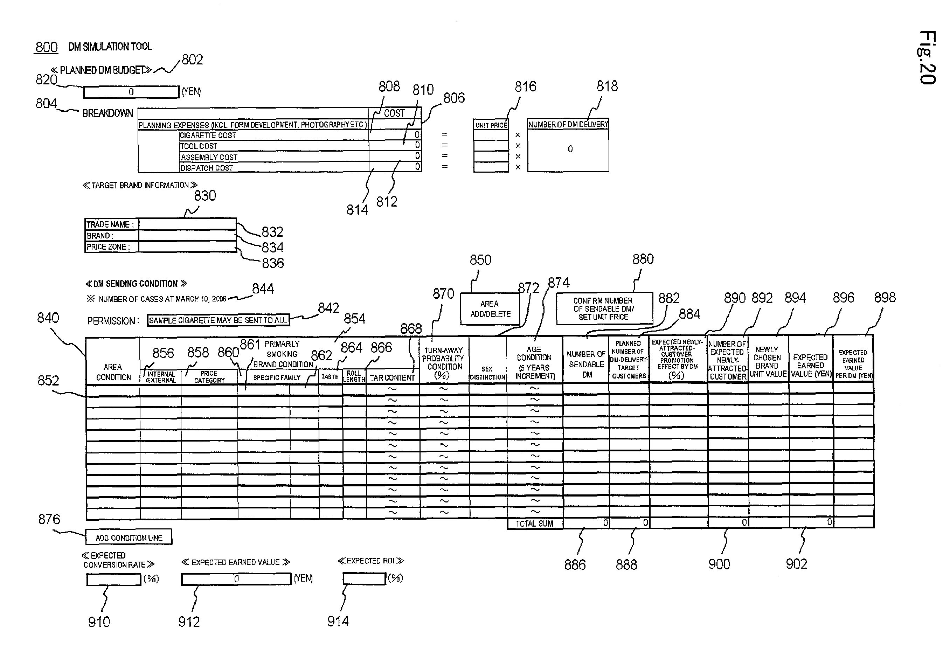

Referring to Figs. 20 to 22, a DM simulation tool arranged for cigarettes as the merchandise to sell will be described hereunder, as a working example of the present invention. In this working example, a DM simulation tool 800 employs a spreadsheet calculation tool such as Excel (registered trademark). Here, it is assumed that, in this working example, a similar configuration to the DM campaign simulation apparatus 100 and the computer 10 of the foregoing embodiment shown in Figs. 2 and 3 is provided, for executing the DM simulation tool 800. In the following passages, Figs. 2 and 3 will also be referred to.

Fig. 20 is an example of a screen displayed by the planning-phase screen display unit 106 of Fig. 2 on the display unit 24 of Fig. 3, upon activating the DM simulation tool 800. As shown in Fig. 20, the DM simulation tool 800 includes, on a single sheet, a planned DM budget column 802, a target brand information column 830, a DM sending condition listing 840, an expected conversion rate column 910, an expected earned value column 912, and an expected ROI column 914.

Accordingly, merely with the input of the budget and conditions on such single sheet by the user, the index values such as the expected conversion rate column 910, the expected earned value column 912 and the expected ROI column 914 are respectively calculated, for review of the result. Fluctuation of ROI and so on can be easily confirmed simply by modifying the condition. For comparing simulation results based on a plurality of condition patterns, the user may reproduce the sheet and specify different conditions on each sheet. Then the user can easily compare the simulation results arising from different conditions.

Manipulation of the sheet, data input or selection on the sheet may be executed by the user via the operation unit 26 of Fig. 3, for acceptance by the planned budget acceptance unit 102, the condition acceptance unit 112, and the plan acceptance unit 116 of the DM campaign simulation apparatus 100 of Fig. 2. The result of the input and selection, and calculation results are displayed on the planning-phase screen display unit 106 of the DM campaign simulation apparatus 100.

To be more detailed, the planned DM budget column 802 includes, as a breakdown listing 804, a planning expense input column 806, a cigarette cost column 808, a tool cost column 810, an assembly cost column 812, a dispatch cost column 814, a unit price input column 816, and a number of DM delivery column 818. To start with, the user inputs a total of fixed cost not associated with the number of DM, such as the planning expense, form development expense and photography cost, in the planning expense input column 806. Such information is input to each column through manipulation of the operation unit 26 of the computer 10 of Fig. 3, to be accepted by the planned budget acceptance unit 102 and stored in the planning-phase information database 104 of Fig. 2.

Then the user inputs the unit prices for the cigarette cost column 808, the tool cost column 810, the assembly cost column 812, and the dispatch cost column 814, as the expenses related with the dispatch of the DM. The unit price of the cigarette cost column 808 means the cost per package of a cigarette sample, in the case of sending the cigarette sample. The unit price of the tool cost column 810 is the cost per set of items to be sent, except the cigarette sample. The unit price of the assembly cost column 812 is the assembly cost per such set. The unit price of the dispatch cost column 814 is the mailing cost per DM. The input information is accepted by the planned budget acceptance unit 102, and stored in the planning-phase information database 104. The stored information is displayed, whenever necessary, in the screen shown in Fig. 20, on the planning-phase screen display unit 106.

The user then inputs the number of DM to be sent, in the number of DM delivery input column 818. The input information is accepted by the planned budget acceptance unit 102, and stored in the planning-phase information database 104. The default is to be set such that the planned number of delivery target customers (number in the total planned number of DM-delivery-target customers column 888 to be described later) calculated according to subsequently specified DM sending conditions is automatically complemented. The calculation of the planned number of delivery target customers is executed by the number of DM delivery calculation unit 114.

Then, the number of DM delivery calculation unit 114 multiplies each cost input in the unit price input column 816 and the number of DM to be sent in the number of DM delivery input column 818 respectively, so that the amount of each cost is automatically calculated and respectively written in the cigarette cost column 808, the tool cost column 810, the assembly cost column 812, and the dispatch cost column 814. Also, the total sum of each cost, that is the total sum of the planning expense input column 806, the cigarette cost column 808, the tool cost column 810, the assembly cost column 812, and the dispatch cost column 814 is automatically calculated and written in a total budget column 820. Such information is also stored in the planning-phase information database 104.

Now, the target brand information column 830 serves for specifying information on which brand the relevant campaign is targeting at for conversion to a primarily consumed product, and includes a brand input column 832, a brand selection column 834, and a price zone selection column 836. The user inputs a brand name to be the object of the conversion apparatus (brand name to be sent) in the brand input column 832. For the brand selection column 834, a brand name to be promoted for conversion (brand name to be sent) is selected from a pull-down list (not shown). The subsequent description also refers to utilization of a pull-down list including a plurality of options for selection of various information to be input to each column, and such pull-down lists are separately stored in a list storage unit which is not shown. For the price zone selection column 836, a price zone is selected out of a pull-down list including such options as ¥270.- or lower, ¥280.-, and ¥300.- or higher. Such input or selected information is accepted by the planned budget acceptance unit 102, and stored in the planning-phase information database 104.

Then the user inputs the DM sending condition and the effect information. The input information is accepted by the condition acceptance unit 112, and stored in the planning-phase information database 104. The DM sending condition listing 840 is a table to which various conditions are input, for automatic calculation of the effect. Firstly, a permission according to the project to be simulated is selected out of options, in the permission selection column 842. The options may be specified as, for example, "sample cigarette may be sent to all" for the DM sampling, "DM may be sent to all" for a closed DM and announcing DM, and "DM may be sent, but not the sample cigarette" for the case of sending a trial DM to those customers to whom the sample cigarette cannot be sent.

Once the selection is provided for the permission selection column 842 out of the pull-down list including the above options, the connection interface (external interface unit 20 of the computer 10 of Fig. 3) makes connection to a server (not shown) containing the calculation data for the number of DM that may be sent, so that latest data for the number calculation is downloaded and stored in the number of sendable DM calculation data storage unit (not shown).

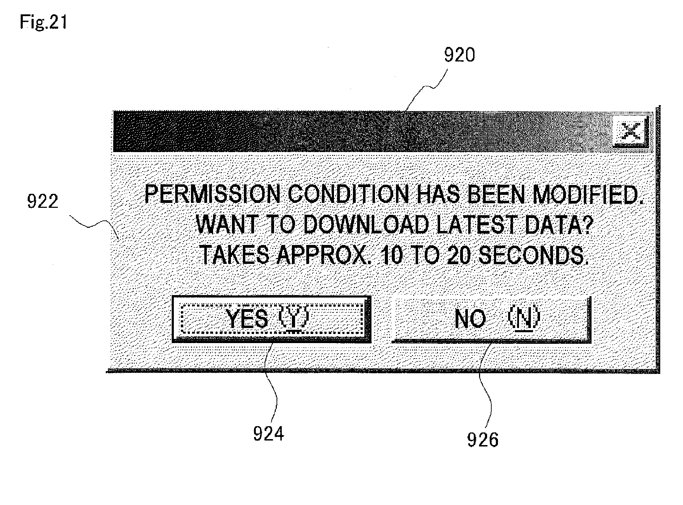

At this stage, the display unit 24 of the computer 10 displays a pop-up of an update confirmation message screen shown in Fig. 21. The update confirmation message screen 920 includes a confirmation message 922, a YES button 924, and a NO button 926. The confirmation message 922 notifies the user to the effect that the permission condition has been modified, and the operation unit 26 accepts the selection on whether to update the data via the manipulation of the YES button 924 or the NO button 926 by the user. Once the operation unit 26 accepts a press of the YES button 924, the connection interface makes connection to the server, to thereby download the number of sendable DM calculation data. Upon completion of the downloading, the date of data update is displayed in the data update date display column 844.

Referring again to Fig. 20, the DM sending condition listing 840 includes an area condition selection column 852, a primarily smoking brand condition column 854, a turn-away probability condition designation column 870, a sex condition selection column 872, and an age condition designation column 874. The primarily smoking brand condition column 854 further includes an internal/external distinction selection column 856, a price category selection column 858, a specified family selection column 860, a taste classification selection column 864, a roll length classification selection column 866, and a tar content designation column 868. It is not necessary to specify all of those condition items, and the unspecified item may be handled as without condition.

A plurality of conditions may be specified, and pressing down a condition line addition button 876 enables adding the condition line. At least one sending condition is to be specified. The sending conditions are accepted by the condition acceptance unit 112, and stored in the planning-phase information database 104. For each column, either the selection is made out of a pull-down list including a plurality of options, or data is directly input, so that the data designated by the user is accepted.

For the area condition selection column 852, the area (prefecture) to send the DM to is selected out of options. When none is selected, "nationwide" is set as the target. Although the area to send the DM to may be designated by prefecture according to the default, the target area may be customized in the case of designating an area encompassing a plurality of prefectures.

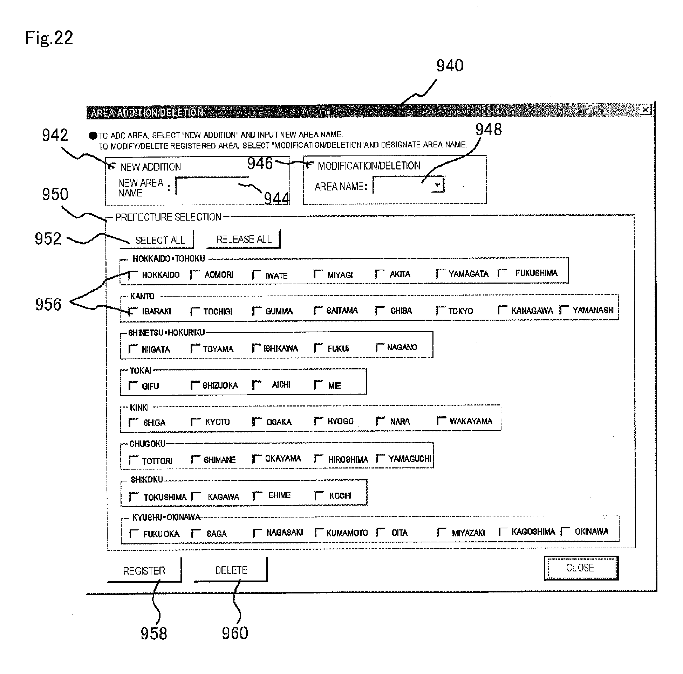

In response to a press of an area addition/deletion button 850 by the user, the operation unit 26 accepts and an area addition/deletion screen 940 of Fig. 22 pops up on the display unit 24. The area addition/deletion screen 940 accepts an addition of the DM-target area, modification of prefectures included in the target area, and deletion of an area.

The selection of the area addition selection radio button 942 or area modification/deletion radio button 946 is accepted by the operation unit 26, and an area editing unit (not shown) executes a process of new area addition or area modification/deletion. The area editing unit adds a new area by the area name input to the additional area input column 944, when the area addition selection radio button 942 is selected. The prefecture modification/deletion selection column 950 includes a listing display of the prefecture names of each area, respectively accompanied with a prefecture selection check box 956. Once the operation unit 26 accepts a press of a registration button 958, the area editing unit registers the prefecture whose prefecture selection check box 956 is marked in an area registration unit (not shown) as a new area, by the area name input in to additional area name input column 944.

Also, when the operation unit 26 accepts a press of an all-select button 952, the area editing unit creates a state that the prefecture selection check box 956 of all the prefectures are selected. On the contrary, when the operation unit 26 accepts a press of an all-release button 954, the area editing unit releases the selection of the prefecture selection check box 956 of all the prefectures.

On the other hand, when the area modification/deletion radio button 946 is selected, an area modification/ deletion selection column 948 displays a pull-down list including as options the area names already registered in the area registration unit on the area modification/deletion selection column 948. The user selects the area name to be modified or deleted out of the pull-down list of the area modification/deletion selection column 948. The operation unit 26 accepts the selected subject area names, and displays a check in the prefecture selection check box 956 of the prefectures already registered.

For modification, the user puts or removes the check in the prefecture selection check box 956 of a desired prefecture, and then presses the registration button 958. The area editing unit registers the modified prefecture again, as an area of the subject area name. For deletion, the user selects the area name to be deleted out of the area modification/ deletion selection column 948, and presses a deletion button 960. The operation unit 26 accepts the press of the deletion button 960, and the area editing unit deletes the subject area name selected in the area modification/deletion selection column 948, from the area registration unit.

Referring again to Fig. 20, selection for the internal/external distinction selection column 856 is made out of such options as "house brand/competitor's brand/unknown". For the price category selection column 858, the selection is made out of the options as "¥270.- or lower/¥280.-/¥300.- or higher" or the like. The specific family selection column 860 further includes a specific family selection column 861 and a specific family condition selection column 862. For the specific family selection column 861, the selection is made out of options of a plurality of cigarette brand families. Further, it is selected whether only the target brand smokers involved in the selected specific family are picked up to be counted as the planned number of DM-delivery-target customers, or target brand smokers of a brand other than the specific family are to be counted, for the specific family condition selection column 862. In the case where the option of "exclude" is selected in the specific family condition selection column 862, the target brand smokers of a brand other than the specific family selected in the specific family selection column 861 are to be counted.

For the taste classification selection column 864, the selection is made from such options as "regular/menthol". When the taste classification selection column 864 is left blank, both of the regular and menthol tastes are picked up as the subject. For the roll length classification selection column 866, the selection is made from such options as "FK/FSK". The tar content designation column 868 accepts designation of an upper limit and lower limit, or either thereof, of the tar content. If a value of 13 mg or higher is specified, no classification is provided.

The turn-away probability condition designation column 870 accepts designation of an upper limit and lower limit, or either thereof, of the turn-away probability. If a value of 30% or higher is specified, no classification is provided. For the sex condition selection column 872, the selection is made from the options as "male/female/unknown". The age condition designation column 874 accepts an upper limit and lower limit, or either thereof, of the age. The selection may be made in 5 years increment.

After the acceptance of the sending conditions, when the operation unit 26 accepts a press of the number of sendable DM confirmation/unit price set button 880, the number of DM delivery calculation unit 114 calculates the number of DM that may be sent based on the number of sendable DM calculation data previously downloaded, and writes the number in the number of sendable DM column 882. Further, the values written in the number of sendable DM column 882 under different conditions are aggregated, and the total sum is written in the total number of sendable DM column 886.

The number of DM delivery calculation unit 114 calculates the newly chosen brand unit value based on the target brand information column 830 and the conditions specified in the foregoing sending conditions, and writes the value in a newly chosen brand unit value column 894. The user inputs the planned number of DM-delivery-target customers in the planned number of DM-delivery-target customers column 884 with respect to each DM sending condition, referring to the number of sendable DM column 882. The input information is accepted by the plan acceptance unit 116. In an input column of expected conversion promotion effect by DM 890, the expected promotion effect of the DM for conversion to target brand is specified with respect to each DM sending condition. The expected effect is a value obtained by subtracting a conversion rate of non-DM-delivery-target customers to the target brand, from a conversion rate of the DM-delivery-target customers to the target brand. A listing showing the past DM promotion effect for conversion to target brand is to be prepared in advance, so that the user may specify the expected effect referring to the listing and input the expectation in the input column of expected conversion promotion effect by DM 890 via the operation unit 26, for acceptance by the plan acceptance unit 116.

Then the expected value calculation unit 120 calculates the number of conversion-expected customers, based on the planned number of delivery target customers input to the planned number of DM-delivery-target customers column 884 and the expected effect (%) input to the input column of expected conversion promotion effect by DM 890, by the following formula (13) with respect to each sending condition.

$$\text{Number of conversion-expected customers} = \text{planned number of delivery-target customers} \times \text{expected effect} / 100 \ldots (13)$$

The number of conversion-expected customers thus calculated is written in a number of conversion-expected customers column 892. Also, the data of the number of conversion-expected customers column 892 with respect to all the sending condition is aggregated, and the aggregated value is written in a total number of conversion-expected customers column 900. Further, the expected value calculation unit 120 calculates the expected earned value from the number of conversion-expected customers in the number of conversion-expected customers column 892 and the newly chosen brand unit value in the newly chosen brand unit value column 894, by the following formula (14).

$$\text{Expected earned value} = \text{number of conversion-expected customers} \times \text{newly chosen brand unit value} \ldots (14)$$

The expected earned value thus calculated is written in an expected earned value column 896. Also the data of the expected earned value column 896 with respect to all the sending conditions is aggregated, and the aggregated value is written in the total expected earned value column 902. Further, the expected value calculation unit 120 calculates the expected earned value per DM from the expected earned value in the expected earned value column 896 and the planned number of DM-delivery-target customers in the planned number of DM-delivery-target customers column 884, by the following formula (15).

$$\text{Expected earned value per DM} = \text{expected earned value} / \text{planned number of DM-delivery-target customers} \dots (15)$$

Upon completion of the foregoing operation and calculation, the expected ROI calculation unit 122 automatically calculates the expected conversion rate, the expected earned value, and the expected ROI, and writes those values in the expected conversion rate column 910, the expected earned value column 912, and the expected ROI column 914, respectively. The expected conversion rate is calculated from the total of the number of conversion-expected customers in the total number of conversion-expected customers column 900 and the total of the planned number of DM-delivery-target customers in the total planned number of DM-delivery-target customers column 888, by the following formula (16).

$$\text{Expected conversion rate} = \text{total number of conversion-expected customers} / \text{total planned number of DM-delivery-target customers} \times 100(\%) \dots (16)$$

Also, the expected earned value is calculated from the number of conversion-expected customers in the number of conversion-expected customers column 892 and the newly chosen brand unit value in the newly chosen brand unit value column 894, by the following formula (17).

$$\text{Expected earned value} = \text{number of conversion-expected customers} \times \text{newly chosen brand unit value} \dots (17)$$

Further, the expected ROI is calculated based on the expected earned value in the expected earned value column 912 calculated by the formula (17) and the planned budget in the total budget column 820, by the foregoing formula (3). The data thus calculated by the expected value calculation unit 120 and the expected ROI calculation unit 122 is stored in the planning-phase information database 104, and displayed on the screen of the DM simulation tool 800 of Fig. 20, by the planning-phase screen display unit 106.

Thus, the DM simulation tool 800 specifies the sending conditions with respect to the DM-delivery-target customers and the expected effect of the DM, thereby enabling estimating the ROI of the relevant campaign and performing anticipated simulation at the time of planning the project. As described above, the DM simulation tool 800 allows selecting and designating the items to be specified as the DM sending condition. Also, designating the items of the DM sending conditions provides indication of the number of DM that may be sent, according to each designated condition. Further, inputting the planned number of DM to be sent and the expected promotion effect for conversion to target brand leads to calculation of the expected earned value of the DM campaign. Still further, from the plan and the expected earned value, the expected ROI can be calculated. With all these functions, variation in expected earned value and ROI under different setting of the condition of the DM-delivery-target customers and the number of DM can be visualized.

Accordingly, calculating the ROI at the time of planning with the DM simulation tool 800 according to this working example allows making a proper decision of investment. Also, visualizing the variation of ROI enables efficiently designating the delivery target customers for the DM campaign. The clear indication of the expected effect of the DM facilitates establishing a goal to be achieved. Further, performing the planning and feed-back evaluation under a common framework enables smoothly evaluating and analyzing the result of the project.

**Claims**

1. A simulation apparatus that predicts an effect of sending out a direct mail of a sales promotion campaign of a product of a specific brand, comprising:

   a planned budget acceptance unit that accepts a planned budget of said campaign;
   a customer master table containing properties and turn-away probability of each customer;
   a condition acceptance unit that accepts a setting of a sending condition for sending said direct mail;
   a number of delivery applicable customers calculation unit that extracts customers corresponding to said sending condition out of said customer master table, and calculates the number of delivery applicable customers to whom said direct mail may be sent;
   a number of delivery applicable customers presentation unit that presents the number of delivery applicable customers;
   a planned number of delivery target customers acceptance unit that accepts a planned number of delivery target customers to whom said direct mail should be sent, with an upper limit being the number of delivery applicable customers;
   an expected conversion rate acceptance unit that accepts an expected conversion rate based on said sending condition;
   a number of conversion-expected customers calculation unit that calculates a number of conversion-expected customers, based on the planned number of delivery target customers and said expected conversion rate;
   a unit value table that stores therein an earned value unit cost per customer, predetermined according to said properties of each brand of said product and indicating a value to be earned by a change made through said campaign on said brand that said customer primarily purchases;
   an expected earned value calculation unit that looks up said unit value table, to acquire said earned value unit cost gained through the conversion to said specific brand, corresponding to said properties of said brand of said product to which said sending condition applies, thereby calculating said expected earned value based on the number of conversion-expected customers;
   an expected ROI calculation unit that calculates an expected ROI based on said planned budget and said expected earned value; and
   a prediction presentation unit that presents said expected earned value and said expected ROI.

2. The simulation apparatus according to claim 1, further comprising:

   a predicted turn-away rate storage unit that stores therein a predicted turn-away rate associated with a behavior pattern of said customer;
   a behavior pattern acquisition unit that acquires said behavior pattern of said customer; and
   a decision unit that compares said behavior pattern of said customer with a predetermined behavior pattern model thereby deciding said predicted turn-away rate;

   wherein said simulation apparatus stores said predicted turn-away rate as said turn-away probability in said customer master table.

3. An effect measurement apparatus that measures an effect of a sales promotion campaign, executed through sending out a direct mail for a sales promotion campaign of a product of a specific brand under a predetermined sending condition and collecting answers to a questionnaire from customers, based on customer information including properties of said customer written on said returned postcard, comprising:

   an acquisition unit that acquires said customer information automatically read out from said postcard;
   an actual result database that acquires, from said customer information, conversion classification information indicating to which brand said customer has shifted his/her primary purchase as a result of said campaign, and accumulates such information of each customer;
   a budget acceptance unit that accepts an input of a budget of said campaign;
   a condition acceptance unit that accepts from said customer information a condition including the properties of said customer who is surveyed;
   a number of sending postcards acceptance unit that accepts a number of postcards to be sent out with respect to each condition;
   a number of newly converted customers calculation unit that calculates a number of newly converted customers based on said conversion classification information with respect to each condition;

a conversion rate calculation unit that calculates a conversion rate based on the number of newly converted customers and the number of sending postcards, with respect to each condition;

a unit value table that contains an earned value unit cost per customer, predetermined according to the properties of each brand of said product, and indicating a value to be earned by a change made through said campaign on said brand that said customer primarily purchases;

an earned value calculation unit that looks up said unit value table, to acquire said earned value unit cost gained through said conversion to said specific brand, corresponding to the properties of said brand of said product to which said sending condition applies, thereby calculating said earned value based on the number of newly converted customers;

a ROI calculation unit that calculates a ROI based on said budget and said earned value; and

an actual result presentation unit that presents said earned value and said ROI.

4.  The effect measurement apparatus according to claim 3, wherein said actual result database accumulates, with respect to each customer, in association therewith, a delivery flag indicating whether said direct mail has been sent, a brand that said customer was purchasing before delivery of said direct mail, a brand that said customer has started purchasing after delivery of said direct mail, and a conversion flag indicating whether said customer has converted to a specific brand after delivery of said direct mail; and includes:

a first counting unit that counts out of said actual result database, with respect to each brand classification, a number of first type customers with said delivery flag indicating that said direct mail was sent and said conversion flag indicating that said customer has converted to said specific brand;

a conversion rate by brand calculation unit that calculates, with respect to each brand classification, conversion rate based on the number of said first type customers and the number of direct mails sent;

a second counting unit that counts out of said actual result database, with respect to each brand classification, a number of second type customers who were purchasing said specific brand before sending said direct mail;

a specific brand purchase rate calculation unit that calculates, with respect to each brand classification, a purchase rate of an existing specific brand based on the number of said second type customers and the total number of customers in said actual result database;

a real conversion rate calculation unit that calculates a real conversion rate achieved by sending said direct mails, based on said purchase rate and said conversion rate, with respect to each brand classification;

a number of customers calculation unit that calculates, with respect to each brand classification, a number of customers gained by sending said direct mails, based on said number of postcards sent and said real conversion rate;

an earned value calculation unit that calculates, with respect to each brand classification, an earned value based on the number of earned customers and said earned value unit cost;

an effect calculation unit that calculates, with respect to each brand classification, an earned value per direct mail based on said number of postcards sent and said earned value; and

a presentation unit that presents, with respect to each brand classification, said conversion rate, said purchase rate, said real conversion rate, said earned value, and said earned value per direct mail.

5.  A sales promotion support system, comprising said simulation apparatus according to claim 1-2, and said effect measurement apparatus according to claim 3-4.

6.  The sales promotion support system according to claim 5, wherein said effect measurement apparatus includes:

a conversion rate accumulation unit that accumulates said conversion rate under each condition, from said customer information;

a norm value calculation unit that calculates a norm value of said accumulated conversion rate; and

a presentation unit that presents said norm value; and

said expected conversion rate acceptance unit of said simulation apparatus that accepts an expected conversion rate decided and input by a user looking up said norm value of said conversion rate presented by said presentation unit of said effect measurement apparatus.

7.  The sales promotion support system according to claim 5-6, wherein said number of delivery applicable customers presentation unit and said prediction presentation unit of said simulation apparatus include a first display unit that displays a planning-phase screen;

said actual result presentation unit of said effect measurement apparatus includes a second display unit that displays an actual result screen; and

said planning-phase screen and said actual result screen employs a similar format.

8. A program of predicting an effect of sending out a direct mail for a sales promotion campaign of a product of a specific brand, causing a computer including:

a customer master table including properties and turn-away probability of each customer; and

a unit value table that contains an earned value unit cost per customer, predetermined according to the properties of each brand of said product and indicating a value to be earned by a change made through said campaign on said brand that said customer primarily purchases; to perform as:

a planned budget acceptance unit that accepts a planned budget of said campaign;

a condition acceptance unit that accepts a setting of a sending condition for sending said direct mail;

a number of delivery applicable customers calculation unit that extracts customers corresponding to said sending condition out of said customer master table, and calculates the number of delivery applicable customers to whom said direct mail may be sent;

a number of delivery applicable customers presentation unit that presents the number of delivery applicable customers;

a planned number of delivery target customers acceptance unit that accepts a planned number of delivery target customers to whom said direct mail should be sent, with an upper limit being the number of delivery applicable customers;

an expected conversion rate acceptance unit that accepts an expected conversion rate based on said sending condition;

a number of conversion-expected customers calculation unit that calculates a number of conversion-expected customers, based on the planned number of delivery target customers and said expected conversion rate;

an expected earned value calculation unit that looks up said unit value table, to acquire said earned value unit cost gained through said conversion to said specific brand, corresponding to said properties of said brand of said product to which said sending condition applies, thereby calculating said expected earned value based on the number of conversion-expected customers;

an expected ROI calculation unit that calculates an expected ROI based on said planned budget and said expected earned value; and

a prediction presentation unit that presents said expected earned value and said expected ROI.

9. A program of measuring an effect of a sales promotion campaign, executed through sending out a direct mail for a sales promotion campaign of a product of a specific brand under a predetermined sending condition and collecting answers to a questionnaire from customers, based on customer information including properties of said customer written on said returned postcard, causing a computer including:

an actual result database that acquires, from said customer information, conversion classification information indicating to which brand said customer has shifted his/her primary purchase as a result of said campaign, and accumulates such information of each customer; and

a unit value table that stores therein an earned value unit cost per customer, predetermined according to said properties of each brand of said product and indicating a value to be earned by a change made through said campaign on said brand that said customer primarily purchases; to perform as:

an acquisition unit that acquires said customer information automatically read out from said postcard;

a budget acceptance unit that accepts an input of a budget of said campaign;

a condition acceptance unit that accepts from said customer information a condition including said properties of said customer who is surveyed;

a number of sending postcards acceptance unit that accepts a number of postcards to be sent out with respect to each condition;

a number of newly converted customers calculation unit that calculates a number of newly converted customers based on said conversion classification information with respect to each condition;

a conversion rate calculation unit that calculates a conversion rate based on the number of newly converted customers and the number of postcards sent, with respect to each condition;

an earned value calculation unit that looks up said unit value table, to acquire said earned value unit cost gained through said conversion to said specific brand, corresponding to the properties of said brand of said product to which said sending condition applies, thereby calculating said earned value based on the number of newly converted customers;

a ROI calculation unit that calculates a ROI based on said budget and said earned value; and

an actual result presentation unit that presents said earned value and said ROI.

Fig.1

40 SMOKERS (APPROX. 300MILLION)

POSTCARD  DM

Web、E-MAIL
MOBILE PHONE
66

BRAND CAMPAIGN
NEW RELEASE
· · · · ·
· · · · ·
· · · · ·
abc

74 SAMPLING
72
· · · · · ·
abc
abc

POST OFFICE

DISPATCH

52
54
56

SCAN   INPUT   SIGNATURE DB

WebDB   64

CUSTOMER MASTER DB   62

70   STORE

50  IMAGE RECOGNITION SYSTEM        60 DATA CENTER

31

Fig.2

100

DM CAMPAIGN SIMULATION APPARATUS

102
PLANNED
BUDGET
ACCEPTANCE
UNIT

104
PLANNING-PHASE
INFORMATION
DB

106
PLANNING-PHASE
SCREEN
DISPLAY UNIT

112
CONDITION
ACCEPTANCE
UNIT

116
PLAN
ACCEPTANCE
UNIT

114
NUMBER OF
DM DELIVERY
CALCULATION UNIT

120
EXPECTED VALUE
CALCULATION
UNIT

122
EXPECTED ROI
CALCULATION
UNIT

108
CUSTOMER
MASTER TABLE

110
BRAND TABLE

118
NEWLY CHOSEN
BRAND UNIT VALUE TABLE

Fig.3

COMPUTER       ~10

CPU ~12

ROM ~14

RAM ~16

22

I／O ~18

I／F ~20

DISPLAY UNIT ~24

OPERATION UNIT ~26

PRINTER ~28

30

33

Fig.4

(a)  130  PLANNING-PHASE
     CAMPAIGN INFORMATION

| | |
|---|---|
| CAMPAIGN ID | ~131 |
| PLANNED BUDGET | ~132 |
| NUMBER OF DM-DELIVERY-APPLICABLE CUSTOMERS | ~133 |
| PLANNED NUMBER OF DM-DELIVERY-TARGET CUSTOMERS | ~134 |
| EXPECTED CONVERSION RATE | ~135 |
| NUMBER OF CONVERSION-EXPECTED CUSTOMERS | ~136 |
| EXPECTED EARNED VALUE | ~137 |
| EXPECTED ROI | ~138 |

(b)  140  PLANNING-PHASE
     SPECIFIED CONDITION

| | | |
|---|---|---|
| CONDITION No. | | ~141 |
| AREA | | ~142 |
| PRIMARILY SMOKING BRAND CONDITION | INTERNAL/EXTERNAL DISTINCTION | ~144 |
| | PRICE CATEGORY | ~145 |
| | TASTE CLASSIFICATION | ~146 |
| | TAR CONTENT | ~147 |
| TURN-AWAY PROBABILITY | | ~148 |
| SEX | | ~149 |
| AGE | | ~150 |

143

(c)  160  PLANNING-PHASE
     INFORMATION
     BY CONDITION

| | |
|---|---|
| CONDITION No. | ~161 |
| NUMBER OF DM-DELIVERY-APPLICABLE CUSTOMERS | ~162 |
| PLANNED NUMBER OF DM-DELIVERY-TARGET CUSTOMERS | ~163 |
| EXPECTED CONVERSION RATE | ~164 |
| NUMBER OF CONVERSION-EXPECTED CUSTOMERS | ~165 |
| NEWLY CHOSEN BRAND UNIT VALUE | ~166 |
| EXPECTED EARNED VALUE | ~167 |

EP 1 936 555 A1

Fig.5

200  PLANNING-PHASE
SCREEN

≪PLANNED DM BUDGET ≫ ≪EXPECTED CONVERSION RATE ≫ ≪EXPECTED EARNED VALUE ≫ ≪EXPECTED ROI ≫

- 202
- 250
- 252
- 254

| 40,000,000 (¥) | 3 (%) | 56,880,000 (¥) | 42.2 (%) |

≪DM SENDING CONDITION ≫ — 204

| AREA CONDITION | PRIMARILY SMOKING BRAND CONDITION | | TASTE | TAR CONTENT | TURN-AWAY PROBABILITY CONDITION | SEX DISTINC -TION | AGE CONDITION | NUMBER OF DM-DELIVERY-APPLICABLE CUSTOMERS | PLANNED NUMBER OF DM-DELIVERY-TARGET CUSTOMERS | EXPECTED CONVERSION RATE | NUMBER OF CONVERSION -EXPECTED CUSTOMERS | NEWLY CHOSEN BRAND UNIT VALUE (YEN) | EXPECTED EARNED VALUE (YEN) |
|---|---|---|---|---|---|---|---|---|---|---|---|---|---|
| | INTERNAL/ EXTERNAL | PRICE CATEGORY | | | | | | | | | | | |
| TOKYO | OUR COMPANY | LESS THAN ¥270 | R | 1 ~ 3 | 20% ~ | MALE | 20 ~ 39 | 12,345 | 5,000 | 2% | 100 | 4,000 | 400,000 |
| TOKYO | OUR COMPANY | LESS THAN ¥270 | M | 1 ~ 5 | 10% ~ | | 20 ~ 39 | 2,154 | 2,000 | 4% | 80 | 4,000 | 320,000 |
| TOKYO | COMPETITOR | LESS THAN ¥270 | R | 1 ~ 3 | ~ | | 20 ~ 49 | 25,685 | 25,000 | 2% | 500 | 24,000 | 12,000,000 |
| TOKYO | COMPETITOR | LESS THAN ¥270 | M | 1 ~ 5 | ~ | | 20 ~ 49 | 46,524 | 46,000 | 4% | 1,840 | 24,000 | 44,160,000 |
| | | | | ~ | ~ | | ~ | | | | | | |
| | | | | ~ | ~ | | ~ | | | | | | |
| | | | | | | | TOTAL SUM | 86,708 | 78,000 | 3% | 2,520 | – | 56,880,000 |

240

206
212
214  216  210  218  220  222  224  226  228  230  232  234  236

35

Fig.6

# 108 CUSTOMER MASTER TABLE

| | |
|---|---|
| ID | ~ 171 |
| PRIMARILY SMOKING BRAND | ~ 172 |
| TURN-AWAY PROBABILITY | ~ 173 |
| SEX | ~ 174 |
| AGE | ~ 175 |
| AREA | ~ 176 |

Fig.7

## 110 BRAND TABLE

| | |
|---|---|
| BRAND | 181 |
| COMPANY NAME | 182 |
| PRICE | 183 |
| TASTE CLASSIFICATION | 184 |
| TAR CONTENT | 185 |

Fig.8

118 NEWLY CHOSEN BRAND UNIT VALUE TABLE

| AFTER CPN / BEFORE CPN | | COMPETITOR BRAND | OTHER BRAND OF OURS | | | | CPN TARGET BRAND | | | |
|---|---|---|---|---|---|---|---|---|---|---|
| | | | ¥270 OR LOWER | ¥280 | ¥290 | ¥300 OR HIGHER | ¥270 OR LOWER | ¥280 | ¥290 | ¥300 OR HIGHER |
| CPN TARGET BRAND | ¥270 OR LOWER | 20,000 | 0 | ▲ 4,000 | ▲ 6,000 | ▲ 8,000 | 1,000 | ▲ 3,000 | ▲ 5,000 | ▲ 7,000 |
| | ¥280 | 24,000 | 4,000 | 0 | ▲ 2,000 | ▲ 4,000 | 5,000 | 1,000 | ▲ 1,000 | ▲ 3,000 |
| | ¥290 | 26,000 | 6,000 | 2,000 | 0 | ▲ 2,000 | 7,000 | 3,000 | 1,000 | ▲ 1,000 |
| | ¥300 OR HIGHER | 28,000 | 8,000 | 4,000 | 2,000 | 0 | 9,000 | 5,000 | 3,000 | 1,000 |

Fig.9

```
                    ( START )
                        |
    +-------------------------------------------+
    |     DISPLAY PLANNING-PHASE SCREEN         |~~~ S11
    +-------------------------------------------+
                        |
    +-------------------------------------------+
    |       ACCEPT PLANNED BUDGET INPUT         |~~~ S13
    +-------------------------------------------+
                        |
    +-------------------------------------------+
    |         ACCEPT CONDITION INPUT            |~~~ S15
    +-------------------------------------------+
                        |
+-----------------------------------------------------------+
| CALCULATE AND DISPLAY NUMBER OF DM-DELIVERY-APPLICABLE     |~~~ S17
| CUSTOMERS                                                 |
+-----------------------------------------------------------+
                        |
+-----------------------------------------------------------+
| ACCEPT NUMBER OF DM-DELIVERY-APPLICABLE CUSTOMERS          |~~~ S19
|         AND EXPECTED CONVERSION RATE INPUT                |
+-----------------------------------------------------------+
                        |
+-----------------------------------------------------------+
| CALCULATE AND DISPLAY NUMBER OF CONVERSION-EXPECTED        |~~~ S21
| CUSTOMERS, NEWLY CHOSEN BRAND UNIT VALUE, EXPECTED        |
| EARNED VALUE                                              |
+-----------------------------------------------------------+
                        |
    +-------------------------------------------+
    |   CALCULATE AND DISPLAY EXPECTED ROI      |~~~ S23
    +-------------------------------------------+
                        |
                    (  END  )
```

## Fig.10

## Fig.11

(a)

330  CAMPAIGN ACTUAL
RESULT INFORMATION

| | |
|---|---|
| CAMPAIGN ID | 331 |
| BUDGET | 332 |
| NUMBER OF DM-DELIVERY-APPLICABLE CUSTOMERS | 333 |
| NUMBER OF DM-DELIVERY-TARGET CUSTOMERS | 334 |
| CONVERSION RATE | 335 |
| NUMBER OF NEWLY CONVERTED CUSTOMERS | 336 |
| EARNED VALUE | 337 |
| ROI | 338 |

(b)

340  ACTUAL RESULT SPECIFIED
CONDITION

| | | |
|---|---|---|
| CONDITION No. | | 341 |
| AREA | | 342 |
| PRIMARILY SMOKING BRAND CONDITION | INTERNAL /EXTERNAL DISTINCTION | 344 |
| | PRICE CATEGORY | 345 |
| | TASTE CLASSIFICATION | 346 |
| | TAR CONTENT | 347 |
| TURN-AWAY PROBABILITY | | 348 |
| SEX | | 349 |
| AGE | | 350 |

343

(c)

360  ACTUAL RESULT
INFORMATION BY CONDITION

| | |
|---|---|
| CONDITION No. | 361 |
| NUMBER OF DM-DELIVERY-APPLICABLE CUSTOMERS | 362 |
| NUMBER OF DM-DELIVERY-TARGET CUSTOMERS | 363 |
| CONVERSION RATE | 364 |
| NUMBER OF NEWLY CONVERTED CUSTOMERS | 365 |
| NEWLY CHOSEN BRAND UNIT VALUE | 366 |
| EARNED VALUE | 367 |

Fig.12

EP 1 936 555 A1

400 ACTUAL RESULT SCREEN

《DM BUDGET》 _402_  45,000,000 (¥)

《CONVERSION RATE》 _430_  5 (%)

《EARNED VALUE》 _432_  85,480,000 (¥)

《ROI》 _434_  90.0 (%)

《DM SENDING CONDITION》 _204_

| AREA CONDITION | PRIMARILY SMOKING BRAND CONDITION | | | | TURN-AWAY PROBABILITY CONDITION | SEX DISTINC-TION | AGE CONDITION | NUMBER OF DM-DELIVERY-APPLICABLE CUSTOMERS | NUMBER OF DM-DELIVERY-TARGET CUSTOMERS | CONVERSION RATE (AT DATE OF RESEARCH) | NUMBER OF NEWLY CONVERTED CUSTOMERS | NEWLY CHOSEN BRAND UNIT VALUE (YEN) | EARNED VALUE (YEN) |
|---|---|---|---|---|---|---|---|---|---|---|---|---|---|
| | INTERNAL/EXTERNAL | PRICE CATEGORY | TASTE | TAR CONTENT | | | | | | | | | |
| TOKYO | OUR COMPANY | LESS THAN ¥270 | R | 1 ~ 3 | 20% ~ | MALE | 20 ~ 39 | 12,345 | 5,000 | 5% | 250 | 4,000 | 1,000,000 |
| TOKYO | OUR COMPANY | LESS THAN ¥270 | M | 1 ~ 5 | 10% ~ | | 20 ~ 39 | 2,154 | 2,000 | 3% | 60 | 4,000 | 240,000 |
| TOKYO | COMPETITOR | LESS THAN ¥270 | R | 1 ~ 3 | ~ | | 20 ~ 49 | 25,685 | 25,000 | 3% | 750 | 24,000 | 18,000,000 |
| TOKYO | COMPETITOR | LESS THAN ¥270 | M | 1 ~ 5 | ~ | | 20 ~ 49 | 46,524 | 46,000 | 6% | 2,760 | 24,000 | 66,240,000 |
| | | | | ~ | ~ | | ~ | | | | | | |
| | | | | ~ | ~ | | ~ | | | | | | |
| | | | | | TOTAL SUM | | | 86,708 | 78,000 | 5% | 3,820 | – | 85,480,000 |

_420_

Fig.13

```
                    ( START )
                        │
     ┌──────────────────────────────────────┐
     │ REPRODUCE PLANNING-PHASE INFORMATION  │⌐∿─ S41
     │       IN ACTUAL RESULT INFORMATION    │
     └──────────────────────────────────────┘
                        │
        ┌──────────────────────────────┐
        │ DISPLAY ACTUAL RESULT SCREEN  │⌐∿─ S43
        └──────────────────────────────┘
                        │
          ┌────────────────────────┐
          │   ACCEPT BUDGET INPUT   │⌐∿─ S45
          └────────────────────────┘
                        │
   ┌─────────────────────────────────────────────────┐
   │ ACCEPT NUMBER OF DM-DELIVERY-TARGET CUSTOMERS INPUT │⌐∿─ S47
   └─────────────────────────────────────────────────┘
                        │
 ┌───────────────────────────────────────────────────────┐
 │ CALCULATE AND DISPLAY CONVERSION RATE FROM NUMBER OF NEWLY │⌐∿─ S49
 │ CONVERTED CUSTOMERS AND NUMBER OF DM-DELIVERY-TARGET CUSTOMERS │
 └───────────────────────────────────────────────────────┘
                        │
 ┌───────────────────────────────────────────────────────┐
 │ CALCULATE AND DISPLAY EARNED VALUE FROM NEWLY CHOSEN      │⌐∿─ S51
 │ BRAND UNIT VALUE AND NUMBER OF NEWLY CONVERTED CUSTOMERS  │
 └───────────────────────────────────────────────────────┘
                        │
          ┌────────────────────────────┐
          │ CALCULATE AND DISPLAY ROI   │⌐∿─ S53
          └────────────────────────────┘
                        │
                    (  END  )
```

Fig.14

Fig.15

502 CUSTOMER INFORMATION

| | |
|---|---|
| ID | 561 |
| CAMPAIGN ID | 562 |
| DM DELIVERY FLAG<br>(1: DELIVERED, 0:UNDELIVERED) | 563 |
| PRIMARILY SMOKING BRAND BEFORE DM DELIVERY | 564 |
| PRIMARILY SMOKING BRAND AFTER DM DELIVERY | 565 |
| NEWLY CHOSEN BRAND FLAG<br>(1: NEWLY CHOSEN, 0:NOT CHOSEN) | 566 |

Fig.16

530  CONVERSION INFORMATION

| COMPANY NAME | 571 |
| --- | --- |
| TASTE CLASSIFICATION | 572 |
| NEWLY-ATTRACTED-CUSTOMER CONVERSION RATE | 573 |
| TARGET BRAND CONSUMPTION RATE | 574 |
| REAL TARGET BRAND CONSUMPTION RATE | 575 |
| NUMBER OF DM DELIVERY | 576 |
| NUMBER OF TARGET BRAND SMOKER | 577 |
| EARNED VALUE | 578 |
| EARNED VALUE PER DM | 579 |

Fig.17

600 CONVERSION
INFORMATION SCREEN

<DM SAMPLING EFFECT>

602                                                          604

| CAMPAIGN NAME | | | (a) EARNED VALUE | ¥84,470,000 (@¥580) |
|---|---|---|---|---|
| CAMPAIGN TYPE | DM SAMPLING | | (b) EXPENSES | ¥56,930,000 (@¥391) |
| TIMING OF CONDUCT | DM DELIVERIED ON OCTOBER 2004 | | (c)= PROFIT (a)-(b) | ¥27,540,000 |
| NUMBER OF TARGET CUSTOMERS | 145,703 PEOPLE | | (d)= ROI (c)÷(b) | 48.4% |

■ CONVERSION STRUCTURE
   BREAKDOWN
                              606

| BRAND CONSUMED BEFORE DMS | | COMPANY A/COMPANY B | | COMPANY C | | OTHER COMPETITOR | | TOTAL |
|---|---|---|---|---|---|---|---|---|
| | | R | M | R | M | R | M | |
| a | NEWLY-ATTRACTED-CUSTOMER CONVERSION RATE AFTER DMS | 0.0% | 7.5% | 0.0% | 9.2% | 2.0% | 7.1% | |
| b | TARGET BRAND CONSUMPTION RATE BEFORE DMS | 0.0% | 6.7% | 0.0% | 2.9% | 0.0% | 1.0% | |
| c=a-b | NEWLY-ATTRACTED-CUSTOMER CONVERSION RATE ACHIEVED DMS | 0.0% | 0.8% | 0.0% | 6.3% | 2.0% | 6.1% | |
| d | TOTAL NUMBER OF DMS DELIVERED | 31,830 | 23,510 | 15,891 | 34,971 | 6,034 | 27,917 | 145,703 |
| e=d*c | NUMBER OF TARGET BRAND SMOKERS GAINED BY DMS | 0 | 188 | 0 | 2,203 | 121 | 1,703 | 4,387 |
| f | EARNED UNIT VALUE | @20,000 | @20,000 | @20,000 | @20,000 | @20,000 | @20,000 | |
| g=f*e | EARNED VALUE | 0 | 3,761,600 | 0 | 44,063,460 | 2,413,600 | 34,058,740 | 84.469,450 |
| h=g÷d | EARNED VALUE PER DMS | 0 | 160 | 0 | 1,260 | 400 | 1,220 | 580 |

Fig.18

START

ACCEPT CAMPAIGN ID INPUT — S80

EXTRACT NEWLY ATTRACTED CUSTOMERS AFTER DM BASED ON CUSTOMER INFORMATION — S81

CALCULATE NEWLY-ATTRACTED-CUSTOMER CONVERSION RATE AFTER DM — S83

EXTRACT PAST TARGET BRAND SMOKERS BEFORE DM FROM CUSTOMER INFORMATION — S85

CALCULATE TARGET BRAND CONSUMPTION RATE BEFORE DM — S87

CALCULATE NEWLY-ATTRACTED-CUSTOMER CONVERSION RATE BY DM EFFECT — S89

CALCULATE TARGET BRAND SMOKERS GAINED BY DM EFFECT — S91

CALCULATE EARNED VALUE — S93

CALCULATE EARNED VALUE PER DM — S95

DISPLAY RESULT SCREEN — S97

END

## Fig.19

700 CAMPAIGN EFFECT SCREEN

<CAMPAIGN EFFECT>

702

| CAMPAIGN NAME | MERCHANDISE A |
|---|---|
| CAMPAIGN TYPE | CLOSED |
| TIMING OF CONDUCT | |
| APPLICANT SITUATION | 82,089 PEOPLE |

704

| (a) EARNED VALUE | ¥157,120,000 |
|---|---|
| (b) EXPENSES | ¥113,780,000 |
| (c)= (a)-(b) PROFIT | ¥43,340,000 |
| (d)= (c)÷(b) ROI | 38.1% |

■ CONVERSION ESTIMATION BEFORE TO AFTER CPN    706

| AFTER CPN \ BEFORE CPN | COMPETITOR BRAND | OTHER BRAND OF OURS | CPN TARGET BRAND | TOTAL |
|---|---|---|---|---|
| CPN TARGET BRAND | 6,101 | 13,670 | 56,338 | 76,109 |
| OTHER BRAND OF OURS | 590 | 2,920 | 514 | 4,024 |
| COMPETITOR BRAND | 891 | 686 | 379 | 1,956 |
| TOTAL | 7,582 | 17,276 | 57,231 | 82,089 |

DETAIL ESTIMATION →

708

| BRAND BEFORE CPN | NUMBER OF APPLICANTS | % | EARNED VALUE |
|---|---|---|---|
| COMPETITOR BRAND | 6,101 | 8% | ¥ 124,700,000 |
| OURS ¥270 OR LOWER | 6,462 | 8% | ¥ 2,370,000 |
| OURS ¥280 | 4,173 | 5% | ▲ ¥14,340,000 |
| OURS ¥290 | 22 | 0% | ▲ ¥140,000 |
| OURS ¥300 OR MORE | 3,013 | 4% | ▲ ¥22,900,000 |
| CPN TARGET BRAND | 56,338 | 74% | ¥39,200,000 |
| TOTAL | 76,109 | 100% | ¥128,890,000 |

■ APPLICANTS DEMOGRAPHICS    710

| | 20's | 30's | 40's | 50's | 60's | TOTAL |
|---|---|---|---|---|---|---|
| MALE | 6,035 | 16,177 | 12,440 | 9,756 | 5,796 | 50,204 |
| FEMALE | 5,918 | 11,314 | 6,285 | 4,559 | 2,365 | 30,441 |
| UNKNOWN | 193 | 464 | 354 | 283 | 150 | 1,444 |
| TOTAL | 12,146 | 27,955 | 19,079 | 14,598 | 8,311 | 82,089 |

■ NEW SUBSCRIBERS: 50,632 (NOVELTY RATE: 62%)    712

49

Fig.20

EP 1 936 555 A1

800 DM SIMULATION TOOL

≪PLANNED DM BUDGET≫ 802

820

| 0 | (YEN) |

804 BREAKDOWN

| | COST |
|---|---|
| PLANNING EXPENSES (INCL. FORM DEVELOPMENT, PHOTOGRAPHY ETC.) | |
| CIGARETTE COST | 0 |
| TOOL COST | 0 |
| ASSEMBLY COST | 0 |
| DISPATCH COST | 0 |

808 810 806

| UNIT PRICE | × | NUMBER OF DM DELIVERY |
|---|---|---|
| | × | 0 |
| | × | |
| | × | |

816 818

814 812

≪TARGET BRAND INFORMATION≫

830

| TRADE NAME : | |
|---|---|
| BRAND : | |
| PRICE ZONE : | |

832 834 836

≪DM SENDING CONDITION≫ 844

※ NUMBER OF CASES AT MARCH 10, 2006

840

852

PERMISSION : | SAMPLE CIGARETTE MAY BE SENT TO ALL | 842

850 AREA ADD/DELETE

872 874

880 CONFIRM NUMBER OF SENDABLE DM/ SET UNIT PRICE

882 884

890 892 894 896 898

| AREA CONDITION | PRIMARILY SMOKING BRAND CONDITION | | | | | | TURN-AWAY PROBABILITY CONDITION (%) | SEX DISTINCTION | AGE CONDITION (5 YEARS INCREMENT) | NUMBER OF SENDABLE DM | PLANNED NUMBER OF DM-DELIVERY-TARGET CUSTOMERS | EXPECTED NEWLY-ATTRACTED-CUSTOMER PROMOTION EFFECT BY DM (%) | NUMBER OF EXPECTED NEWLY-ATTRACTED-CUSTOMER | NEWLY CHOSEN BRAND UNIT VALUE | EXPECTED EARNED VALUE (YEN) | EXPECTED EARNED VALUE PER DM (YEN) |
|---|---|---|---|---|---|---|---|---|---|---|---|---|---|---|---|---|
| | INTERNAL /EXTERNAL | PRICE CATEGORY | SPECIFIC FAMILY | TASTE | ROLL LENGTH | TAR CONTENT | | | | | | | | | | |
| | | | | | | ~ | ~ | | ~ | | | | | | | |
| | | | | | | ~ | ~ | | ~ | | | | | | | |
| | | | | | | ~ | ~ | | ~ | | | | | | | |
| | | | | | | ~ | ~ | | ~ | | | | | | | |
| | | | | | | ~ | ~ | | ~ | | | | | | | |
| | | | | | | ~ | ~ | | ~ | | | | | | | |
| | | | | | | ~ | ~ | | ~ | | | | | | | |
| | | | | | | ~ | ~ | | ~ | | | | | | | |
| | | | | | | ~ | ~ | | ~ | | | | | | | |
| | | | | | | ~ | ~ | | ~ | | | | | | | |
| | | | | | | | TOTAL SUM | | | 0 | 0 | | 0 | | 0 | |

856 858 860 861 862 864 866 854 868 870

876 | ADD CONDITION LINE |

886 888 900 902

≪EXPECTED CONVERSION RATE≫

| | (%) |

≪EXPECTED EARNED VALUE≫

| 0 | (YEN) |

≪EXPECTED ROI≫

| | (%) |

910 912 914

50

Fig.21

920

922

PERMISSION CONDITION HAS BEEN MODIFIED.
WANT TO DOWNLOAD LATEST DATA?
TAKES APPROX. 10 TO 20 SECONDS.

YES (Y)          NO (N)

924          926

Fig.22

## INTERNATIONAL SEARCH REPORT

| | International application No. |
|---|---|
| | PCT/JP2006/318830 |

A. CLASSIFICATION OF SUBJECT MATTER
*G06Q10/00*(2006.01)i, *G06F19/00*(2006.01)i

According to International Patent Classification (IPC) or to both national classification and IPC

B. FIELDS SEARCHED

Minimum documentation searched (classification system followed by classification symbols)
G06Q10/00, G06F19/00

Documentation searched other than minimum documentation to the extent that such documents are included in the fields searched
Jitsuyo Shinan Koho          1922-1996    Jitsuyo Shinan Toroku Koho    1996-2006
Kokai Jitsuyo Shinan Koho    1971-2006    Toroku Jitsuyo Shinan Koho    1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2004-102349 A  (Oki Electric Industry Co., Ltd.), 02 April, 2004 (02.04.04), Full text; all drawings (Family: none) | 1-9 |
| A | JP 2002-334201 A  (Supreme System Consulting Corp.), 22 November, 2002 (22.11.02), Full text; all drawings & US 2002/0128910 A1 | 1-9 |
| A | JP 2002-358403 A  (NTT Data Corp.), 13 December, 2002 (13.12.02), Full text; all drawings (Family: none) | 1-9 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 22 November, 2006 (22.11.06) | 05 December, 2006 (05.12.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**EP 1 936 555 A1**

| INTERNATIONAL SEARCH REPORT | International application No.<br>PCT/JP2006/318830 |
|---|---|

C (Continuation).   DOCUMENTS CONSIDERED TO BE RELEVANT

| Category* | Citation of document, with indication, where appropriate, of the relevant passages | Relevant to claim No. |
|---|---|---|
| A | JP 11-219481 A  (Nomura Research Institute, Ltd.),<br>10 August, 1999 (10.08.99),<br>Full text; all drawings<br>(Family: none) | 1-9 |
| A | Naoki FUJIMOTO et al., "Oracle no CRM Senryaku", Shohan, Ohmsha, Ltd., 25 April, 2001 (25.04.01), ISBN 4-274-06414-X, pages 73 to 82 | 1-9 |
| A | Jilly Dyche "e-Data Data kara Knowledge e Detaware House Jissen no Tebiki" Shohan (e-Data Turning Data into Information with Data Warehousing), PEARSONEDUCATION JAPAN, 2000.12.20, ISBN 4-89471-313-6, p.61-63, 229-230 | 1-9 |

Form PCT/ISA/210 (continuation of second sheet) (April 2005)

54

**EP 1 936 555 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003091630 A